(19) **Europäisches Patentamt**
**European Patent Office**
**Office européen des brevets**

(11) **EP 2 475 038 B1**

(12) **EUROPEAN PATENT SPECIFICATION**

(45) Date of publication and mention
of the grant of the patent:
**13.08.2014 Bulletin 2014/33**

(51) Int Cl.:
*H01M 8/04* $^{(2006.01)}$     *H01M 8/10* $^{(2006.01)}$
*H01M 8/06* $^{(2006.01)}$

(21) Application number: **10813467.7**

(22) Date of filing: **24.08.2010**

(86) International application number:
**PCT/JP2010/005203**

(87) International publication number:
**WO 2011/027512 (10.03.2011 Gazette 2011/10)**

(54) **FUEL CELL POWER GENERATION SYSTEM AND METHOD FOR OPERATING THE SAME**

BRENNSTOFFZELLEN-STROMERZEUGUNGSSYSTEM UND BETRIEBSVERFAHREN DAFÜR

DISPOSITIF DE PRODUCTION D'ÉNERGIE DE PILE À COMBUSTIBLE ET PROCÉDÉ DE
FONCTIONNEMENT ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **02.09.2009 JP 2009202207**

(43) Date of publication of application:
**11.07.2012 Bulletin 2012/28**

(73) Proprietor: **Panasonic Corporation
Kadoma-shi
Osaka 571-8501 (JP)**

(72) Inventors:
• **UMEDA, Takahiro
Osaka 540-6207 (JP)**
• **SUGAWARA, Yasushi
Osaka 540-6207 (JP)**
• **SHIBATA, Soichi
Osaka 540-6207 (JP)**
• **NAKAYAMA, Atsushi
Osaka 540-6207 (JP)**
• **NAKAMURA, Akinari
Osaka 540-6207 (JP)**

(74) Representative: **Grünecker, Kinkeldey,
Stockmair & Schwanhäusser
Leopoldstrasse 4
80802 München (DE)**

(56) References cited:
**WO-A1-01/01508     JP-A- 2006 185 750
JP-A- 2008 103 227     JP-A- 2008 218 050
JP-B2- 8 024 050     US-A1- 2006 249 399**

• **NAGAHARA Y ET AL: "The impact of air
contaminants on PEMFC performance and
durability", JOURNAL OF POWER SOURCES,
ELSEVIER SA, CH, vol. 182, no. 2, 1 August 2008
(2008-08-01), pages 422-428, XP022732200, ISSN:
0378-7753, DOI: 10.1016/J.JPOWSOUR.
2007.12.091 [retrieved on 2008-01-04]**
• **SHI ET AL: "Hydrogen sulfide poisoning and
recovery of PEMFC Pt-anodes", JOURNAL OF
POWER SOURCES, ELSEVIER SA, CH, vol. 165,
no. 2, 28 February 2007 (2007-02-28), pages
814-818, XP005914531, ISSN: 0378-7753, DOI:
10.1016/J.JPOWSOUR.2006.12.052**

Note: Within nine months of the publication of the mention of the grant of the European patent in the European Patent
Bulletin, any person may give notice to the European Patent Office of opposition to that patent, in accordance with the
Implementing Regulations. Notice of opposition shall not be deemed to have been filed until the opposition fee has been
paid. (Art. 99(1) European Patent Convention).

**EP 2 475 038 B1**

## Description

### Technical Field

The present invention relates to a fuel cell power generation system configured to suppress a voltage decrease by suppressing a decrease in catalytic activity by a sulfur compound and improve power generation efficiency and durability, and to a method for operating the fuel cell power generation system.

### Background Art

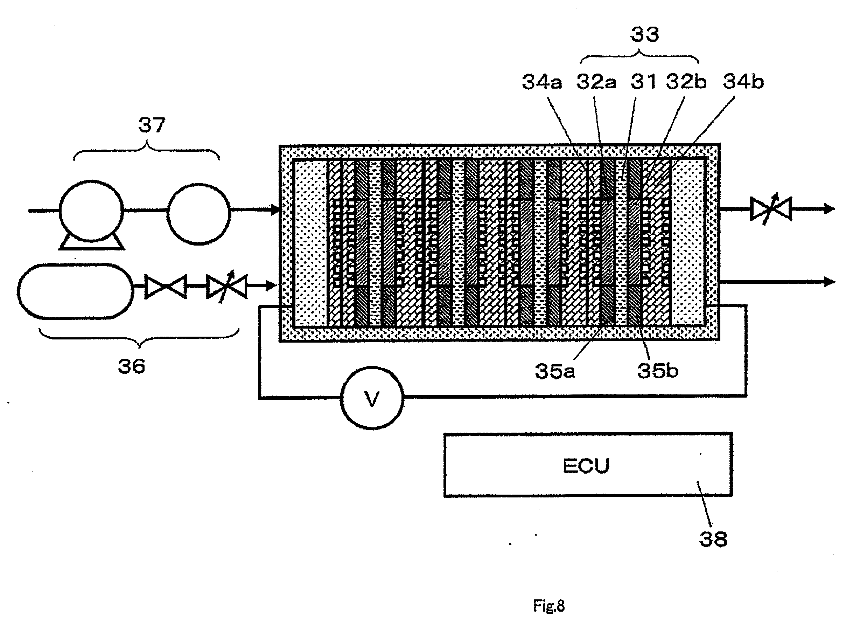

As shown in Fig. 8, a conventionally common fuel cell power generation system includes a stack configured by stacking a plurality of fuel cells 33. Each of the fuel cells 33 includes an anode 32a to which a fuel gas is supplied and a cathode 32b to which an oxidizing gas is supplied. The anode 32a and the cathode 32b are provided so as to sandwich a polymer electrolyte 31 and be opposed to each other.

The fuel gas is supplied to the anode 32a through a separator 34a on which a gas channel is formed. The oxidizing gas is supplied to the cathode 32b through a separator 34b on which a gas channel is formed.

A fuel gas supply portion 36 configured to supply the fuel gas to the anode 32a and an oxidizing gas supply portion 37 configured to supply an oxidizing gas to the cathode 32b are connected to the stack configured as above. The stack is controlled by a control portion 38 to become a desired electric power generation state.

Conventionally, in some cases, this type of fuel cell power generation system is influenced by various impurities to cause decreases in voltage, power generation efficiency, and durability.

As the impurities, there are internal impurities generated from members, such as resin parts and metal parts, constituting the fuel cell power generation system and external impurities getting inside from outside, such as atmosphere. These impurities poison or cover the anode 32a and the cathode 32b. Because of this, an electric power generating reaction is less likely to occur, and the voltage decreases.

Especially, it is known that among pollutants in the atmosphere, sulfur compounds, such as sulfur oxide and hydrogen sulfide, are strongly adsorbed to the surface of the catalyst of the cathode 32b to decrease the catalytic activity.

In accordance with the conventional fuel cell power generation system, to remove the influences of the adsorbed sulfur compounds, during the electric power generation of the fuel cell 33, the load of the fuel cell 33 is caused to become a low load state, and an electrode potential of the cathode 32b to which the impurities are adsorbed is increased. Thus, the impurities adsorbed to the catalyst of the cathode 32b are oxidized to be desorbed. Simultaneously, the amount of water contained in the catalyst layer is increased, and the oxide is washed away by the water to be removed (see PTL 1, for example).

### Citation List

### Patent Literature

PTL 1: Japanese Laid-Open Patent Application Publication No. 2008-218050

### Summary of Invention

### Technical Problem

However, in the case of just oxidizing the sulfur compound adhered to the electrode of the conventional fuel cell and washing away the oxide by water to remove the oxide, the activation of the electrode catalyst is inadequate. The problem is that by generating the electric power for a long period of time, the catalytic activity gradually decreases, the voltage of the fuel cell decreases, and the electric power generating performance decreases.

The present invention was made to solve the above conventional problem, and an object of the present invention is to provide a fuel cell power generation system having an excellent electric power generating performance and configured such that a decrease in voltage of a fuel cell by long-term electric power generation is unlikely to occur since an electrode is reduced after sulfur compounds adsorbed to the electrode are oxidized and removed, and a method for operating such fuel cell power generation system.

### Solution to Problem

To solve the above conventional problem, a fuel cell power generation system of the present invention includes: a fuel cell configured to generate electric power using a fuel gas supplied to an anode thereof and an oxidizing gas supplied to a cathode thereof; a fuel gas supply mechanism configured to supply the fuel gas to the anode; an oxidizing gas supply mechanism configured to supply the oxidizing gas to the cathode; an electric power output unit configured to supply the electric power generated by the fuel cell to an internal load and external load of the fuel cell system; a cooling mechanism configured to cool the fuel cell; and a controller configured to carry out a first step in which the controller controls the electric power supplied from the electric power output unit to at least one of the internal load and the external load such that a voltage of the fuel cell temporarily becomes equal to or higher than a first voltage by which a sulfur compound adhered to the cathode oxidizes, and then, carry out a second step in which the controller causes the cooling mechanism to cool the fuel cell to condense steam in the fuel cell and stops supplying the oxidizing gas from the oxidizing gas supply mechanism.

With this, by the first step, the sulfur compound adhered to the cathode is oxidized, binding force between the catalyst of the cathode and the sulfur compound is weakened, and the sulfur compound can be easily desorbed from the catalyst of the cathode.

Moreover, in the second step after the first step, the steam in the stack is condensed to generate condensed water, and the sulfur compound oxidized in the first step is dissolved in the condensed water. Thus, the sulfur compound can be removed from the catalyst of the cathode.

Moreover, the supply of the oxidizing gas is stopped in the second step. With this, the electrode potential of the cathode from which the sulfur compound has been removed decreases, and the catalyst is reduced. Therefore, the catalyst of the cathode can be adequately activated.

Further, the catalyst to which the impurity, such as the sulfur compound, is not adsorbed is activated by decreasing the electrode potential of the cathode. In addition, since the sulfur compound adhered to the catalyst of the cathode is removed in the second step, the amount of catalyst to which the impurity is not adhered can be increased, and a larger amount of catalyst can be reduced and activated.

The above object, other objects, features and advantages of the present invention will be made clear by the following detailed explanation of preferred embodiments with reference to the attached drawings.

**Advantageous Effects of Invention**

In accordance with the fuel cell power generation system and its operating method of the present invention, even if the impurity, such as the sulfur compound, is adsorbed to the electrode, it can be removed, and the catalyst can be activated. Therefore, even if the fuel cell power generation system continuously generates electric power for a long period of time, the voltage decrease of the fuel cell hardly accumulates, and high power generation efficiency can be maintained for a long period of time. Thus, the power generation efficiency and the durability can be improved.

**Brief Description of Drawings**

[Fig. 1] Fig. 1 is a schematic diagram showing a schematic configuration of a fuel cell power generation system in Embodiment 1 of the present invention.

[Fig. 2] Fig. 2 is a schematic diagram showing the configuration of an electric circuit of the fuel cell power generation system in Embodiment 1 shown in Fig. 1.

[Fig. 3] Fig. 3 is a flow chart showing an operating sequence of the fuel cell power generation system in Embodiment 1 shown in Fig. 1.

[Fig. 4] Fig. 4 is a property diagram showing an electric power generation property of the fuel cell power generation system in Embodiment 1 shown in Fig. 1.

[Fig. 5] Fig. 5 is a time chart showing the operating sequence of the fuel cell power generation system in Embodiment 1 shown in Fig. 1.

[Fig. 6] Fig. 6 is a flow chart showing the operating sequence of the fuel cell power generation system in Embodiment 2 of the present invention.

[Fig. 7] Fig. 7 is a flow chart showing the operating sequence of the fuel cell power generation system in Embodiment 3 of the present invention.

[Fig. 8] Fig. 8 is a schematic diagram showing a schematic configuration of a conventional fuel cell power generation system.

**Description of Embodiments**

First, various features in embodiments of the present invention will be described below.

A fuel cell system of a first aspect includes: a fuel cell configured to generate electric power using a fuel gas supplied to an anode thereof and an oxidizing gas supplied to a cathode thereof; a fuel gas supply mechanism configured to supply the fuel gas to the anode; an oxidizing gas supply mechanism configured to supply the oxidizing gas to the cathode; an electric power output unit configured to supply the electric power generated by the fuel cell to an internal load and external load of the fuel cell system; a cooling mechanism configured to cool the fuel cell; and a controller configured to carry out a first step in which the controller controls the electric power supplied from the electric power output unit to at least one of the internal load and the external load such that a voltage of the fuel cell temporarily becomes equal to or higher than a first voltage by which a sulfur compound adhered to the cathode oxidizes, and then, carry out a second step in which the controller causes the cooling mechanism to cool the fuel cell to condense steam in the fuel cell and stops supplying the oxidizing gas from the oxidizing gas supply mechanism.

Here, the above wording "carry out the first step, and then, carry out the second step" denotes not only a case where the second step is carried out immediately after the termination of the first step but also a case where the second step is carried out after a predetermined time has elapsed since the termination of the first step. To be specific, an electric power generation step or the like may be carried out between the first step and the second step. Moreover, the second step may be carried out after the first step is carried out plural times. Even in any of these cases, since the sulfur compound oxidized in the first step is not reduced, the sulfur compound oxidized in the first step can be removed in the second step. If the second step is carried out immediately after the first step, a larger amount of catalyst can be activated.

With this configuration, by the first step, the sulfur compound adhered to the cathode is oxidized, binding force between the catalyst of the cathode and the sulfur compound is weakened, and the sulfur compound can be easily desorbed from the catalyst of the cathode. Moreover, in the second step after the first step, the steam in the stack is condensed to generate condensed water, and the sulfur compound oxidized in the first step is dissolved in the condensed water. Thus, the sulfur compound can be removed from the catalyst of the cathode.

Moreover, the supply of the oxidizing gas is stopped in the second step. With this, the electrode potential of the cathode from which the sulfur compound has been removed decreases, and the catalyst is reduced. Therefore, the catalyst of the cathode can be adequately activated.

Further, the catalyst to which the impurity, such as the sulfur compound, is not adsorbed is activated by decreasing the electrode potential of the cathode. In addition, since the sulfur compound adhered to the catalyst of the cathode is removed in the second step, the amount of catalyst to which the impurity is not adhered can be increased, and a larger amount of catalyst can be reduced and activated.

Moreover, with this configuration, since the steam in the fuel cell can be condensed quickly, the second step can be carried out in a short period of time. On this account, the temperature decrease of the fuel gas supply mechanism by the stop of the electric power generation is suppressed, and this can decrease the time and energy used to restart the electric power generation. Thus, the stability of the fuel gas supply mechanism can be improved.

The fuel cell system of a second aspect is configured such that in the fuel cell system of the first aspect, the controller is configured to carry out the first step each time an accumulated time of electric power generation of the fuel cell reaches a first electric power generation accumulated time and carry out the second step each time the accumulated time of the electric power generation of the fuel cell reaches a second electric power generation accumulated time longer than the first electric power generation accumulated time.

With this configuration, each time the accumulated time reaches the first electric power generation accumulated time during the electric power generation, that is, at comparatively short intervals, the electrode potential of the cathode is temporarily increased without stopping the fuel cell power generation system. Thus, the sulfur compound adhered to the cathode is oxidized, the binding force between the catalyst of the cathode and the sulfur compound is weakened, and the sulfur compound can be easily desorbed from the catalyst of the cathode. Then, each time the accumulated time reaches the second electric power generation accumulated time longer than the first electric power generation accumulated time, the steam in the fuel cell is condensed, and the supply of the oxidizing gas is stopped. Thus, the desorbed impurity can be washed away, the electrode potential of the cathode can be decreased, and the catalyst can be reduced and activated.

Therefore, it is unnecessary to stop the electric power generation of the fuel cell system except for an extremely short period of time in which the supply of the oxidizing gas is stopped in the second step, and the influence of the sulfur compound on the electric power generation can be eased. Therefore, the fuel cell power generation system can operate for a long period of time until the accumulated time reaches the second electric power generation accumulated time, and the number of start-up and stop operations can be decreased. On this account, it is possible to obtain the fuel cell power generation system which suppresses the energy consumed by the start-up and stop operations of the fuel cell system and excels in overall efficiency.

The second step does not have to be carried out immediately after the accumulated time has reached the second electric power generation accumulated time. The second step may be carried out when stopping the fuel cell power generation system after the accumulated time has reached the second electric power generation accumulated time.

The fuel cell system of a third aspect is configured such that in the fuel cell system of the first aspect, the controller is configured to carry out the first step each time an oxidizing gas accumulated supply amount obtained by accumulating the amount of oxidizing gas supplied reaches a first accumulated supply amount and carry out the second step each time the oxidizing gas accumulated supply amount reaches a second accumulated supply amount larger than the first accumulated supply amount.

With this configuration, if the average concentration of the sulfur compound in the oxidizing gas is substantially constant, the amount of sulfur compound accumulated in the catalyst of the cathode can be calculated from the amount of oxidizing gas supplied to the cathode of the fuel cell. Therefore, the sulfur compound can be efficiently oxidized and removed.

For example, an accumulated amount of the supply amount of oxidizing gas may be set as the first accumulated supply amount, the accumulated amount being calculated in advance by experiments or the like and proportional to the accumulated amount of sulfur compound which influences the cell performance. Moreover, for example, the supply amount of oxidizing gas may be set as the second accumulated supply amount, the supply amount being calculated in advance by experiments or the like and proportional to the accumulated amount of sulfur compound which can be removed by one stop operation of the electric power generation of the fuel cell.

The fuel cell system of a fourth aspect is configured, in addition to the fuel cell system of the first aspect, to further include a voltage detector configured to measure the voltage of the fuel cell, wherein the controller is configured to carry out the first step each time an accumulated time of electric power generation of the fuel cell reaches a first electric power generation accumulated time and carry out the second step each time an accumulated value obtained by accumulating a time in which the voltage detected by the voltage detector is equal to or lower than a second voltage lower than the first voltage reaches a first voltage accumulated time.

With this configuration, even in a case where the influence of the adsorption of the sulfur dioxide on the voltage decrease becomes relatively large since, for example, the concentration of the sulfur dioxide contained in the oxidizing gas is high or the effective reaction area of the catalyst of the cathode is decreased by, for example, the repetition of the electric power generation of the fuel cell for a long period of time, the sulfur dioxide is removed in accordance with the voltage of the fuel cell which decreases since the sulfur dioxide is adsorbed to the catalyst of the cathode of the fuel cell. Therefore, the power generation efficiency and the durability can be improved as compared to a case where the first step and the second step are carried out based on the electric power generation time and the supply amount of oxidizing gas.

The fuel cell system of a fifth aspect is configured, in addition to the fuel cell system of any one of the first to fourth aspects, to further include a first relay configured to allow or block electrical connection between the external load and the fuel cell, wherein the controller is configured to cut the connection between the external load and the fuel cell by the first relay to stop supplying the electric power the external load in the first step.

The fuel cell system of a sixth aspect is configured such that in the fuel cell system of any one of the first to fifth aspects, the controller is configured to decrease the electric power supplied from the electric power output unit to at least one of the internal load and the external load in the second step.

With this configuration, in the second step, by decreasing the amount of electric power generated in the fuel cell, the electrode potential of the cathode can be decreased without any deterioration, such as polarity inversion. On this account, the catalyst of the cathode can be reduced and activated without stopping the electric power generation of the fuel cell. Therefore, the fuel cell power generation system can continuously operate for a long period of time, the number of start-up and stop operations can be decreased, and the energy consumed by the start-up and stop operations can be suppressed. Thus, it is possible to obtain the fuel cell power generation system which excels in overall efficiency.

The fuel cell system of a seventh aspect is configured such that in the fuel cell system of any one of the first to fifth aspects, the controller is configured to stop the electric power supplied from the electric power output unit to the internal load and the external load in the second step.

With this configuration, the supply of the oxidizing gas is stopped, and the electric power generation of the fuel cell is stopped. Thus, the heat generated by the electric power generation of the fuel cell is not generated. On this account, the fuel cell can be cooled more quickly. On this account, the generation of the condensed water in the fuel cell can be further promoted, and the time in which the second step is carried out can be further shortened. Moreover, since the steam in the stack is condensed while the fuel cell stops, the voltage decrease by flooding can be prevented.

The fuel cell system of an eighth aspect is configured, in addition to the fuel cell system of the seventh aspect, to further include: the first relay configured to allow or block the electrical connection between the external load and the fuel cell; and a second relay configured to allow or block the electrical connection between the internal load and the fuel cell, wherein the controller is configured to cut the connection between the external load and the fuel cell by the first relay and cut the connection between the internal load and the fuel cell by the second relay to stop supplying the electric power to the internal load and the external load in the second step.

With this configuration, by stopping the supply of the electric power to the internal load and the external load, the electric power generation of the fuel cell can be stopped, and the electrode potential of the cathode of the fuel cell can be set in an open circuit condition to become a high potential. To be specific, in the second step, before the oxidized sulfur compound is washed away by the condensed water, the electrode potential of the cathode can be temporarily set in the open circuit condition.

With this, in not only the first step but also the second step, before washing away the oxidized sulfur compound by the condensed water, the sulfur compound adhered to the catalyst of the cathode can be oxidized, the binding force between the catalyst and the impurity can be weakened, and the impurity can be desorbed from the catalyst. On this account, a larger amount of sulfur compound can be removed, and a larger amount of catalyst of the cathode can be activated.

The fuel cell system of a ninth aspect is configured, in addition to the fuel cell system of any one of the first to eighth aspects, to further include: an oxidizing gas supply passage connecting the oxidizing gas supply mechanism and the cathode of the fuel cell; a first valve disposed on the oxidizing gas supply passage; an oxidizing gas discharge passage which is connected to the cathode of the fuel cell and to which the oxidizing gas supplied to the cathode of the fuel cell is discharged; and a second valve disposed on the oxidizing gas discharge passage, wherein the controller is configured to seal the cathode of the fuel cell by the first valve and the second valve to stop supplying the oxidizing gas from the oxidizing gas supply mechanism to the cathode in the second step.

With this configuration, in the second step, the oxygen getting into the cathode from the outside is blocked, and the oxygen concentration in the cathode decreases quickly. On this account, since the electrode potential of the cathode decreases quicldy to be maintained at a low potential, the catalyst of the cathode can be reduced quicldy to be activated.

The fuel cell system of a tenth aspect is configured such that in the fuel cell system of any one of the first to ninth aspects, the controller causes the fuel gas supply mechanism and the oxidizing gas supply mechanism to decrease the amount of fuel gas supplied and the amount of oxidizing gas supplied in the first step.

With this configuration, the consumption amounts of the fuel gas and oxidizing gas which do not contribute to the electric power generation of the fuel cell can be decreased, and the power consumption consumed by the operations of the fuel gas supply mechanism and the oxidizing gas supply mechanism can be suppressed. Further, the amount of change in the flow rate of the fuel gas (off gas) discharged from the anode of the fuel cell can be minimized. The off gas is typically consumed in the fuel gas supply mechanism. Therefore, in the case of adopting the fuel gas supply mechanism configured to combust the off gas, the stability of the fuel gas supply mechanism can be maintained, and it is possible to obtain the fuel cell power generation system which has high power generation efficiency and excels in stability.

A method for operating a fuel cell power generation system of Embodiment 1, the fuel cell power generation system including: a fuel cell configured to generate electric power using a fuel gas supplied to an anode thereof and an oxidizing gas supplied to a cathode thereof; a fuel gas supply mechanism configured to supply the fuel gas to the anode; an oxidizing gas supply mechanism configured to supply the oxidizing gas to the cathode; an electric power output unit configured to supply the electric power generated by the fuel cell to an internal load and external load of the fuel cell system; and a cooling mechanism configured to cool the fuel cell, includes: a first step of controlling the electric power supplied from the electric power output unit to at least one of the internal load and the external load such that a voltage of the fuel cell temporarily becomes equal to or higher than a first voltage by which a sulfur compound adhered to the cathode oxidizes; and a second step of causing the cooling mechanism to cool the fuel cell to condense steam in the fuel cell and stopping supplying the oxidizing gas from the oxidizing gas supply mechanism, the second step being carried out after the first step.

With this configuration, by the first step, the sulfur compound adhered to the cathode is oxidized, binding force between the catalyst of the cathode and the sulfur compound is weakened, and the sulfur compound can be easily desorbed from the catalyst of the cathode. Moreover, in the second step after the first step, the steam in the stack is condensed to generate condensed water, and the sulfur compound oxidized in the first step is dissolved in the condensed water. Thus, the sulfur compound can be removed from the catalyst of the cathode.

Moreover, the supply of the oxidizing gas is stopped in the second step. With this, the electrode potential of the cathode from which the sulfur compound has been removed decreases, and the catalyst is reduced. Therefore, the catalyst of the cathode can be adequately activated.

Further, the catalyst to which the impurity, such as the sulfur compound, is not adsorbed is activated by decreasing the electrode potential of the cathode. In addition, since the sulfur compound adhered to the catalyst of the cathode is removed in the second step, the amount of catalyst to which the impurity is not adhered can be increased, and a larger amount of catalyst can be reduced and activated.

Moreover, with this configuration, since the steam in the fuel cell can be condensed quickly, the second step can be carried out in a short period of time. On this account, the temperature decrease of the fuel gas supply mechanism by the stop of the electric power generation is suppressed, and this can decrease the time and energy used to restart the electric power generation. Thus, the stability of the fuel gas supply mechanism can be improved.

Hereinafter, embodiments of the present invention will be explained in reference to the drawings. However, the present invention is not limited to these embodiments. In the drawings, the same reference signs are used for the same or corresponding components, and a repetition of the same explanation is avoided. Further, in the drawings, only the components necessary to explain the present invention are shown, and the other components are omitted.

**Embodiment 1**

**Configuration of Fuel Cell Power Generation System**

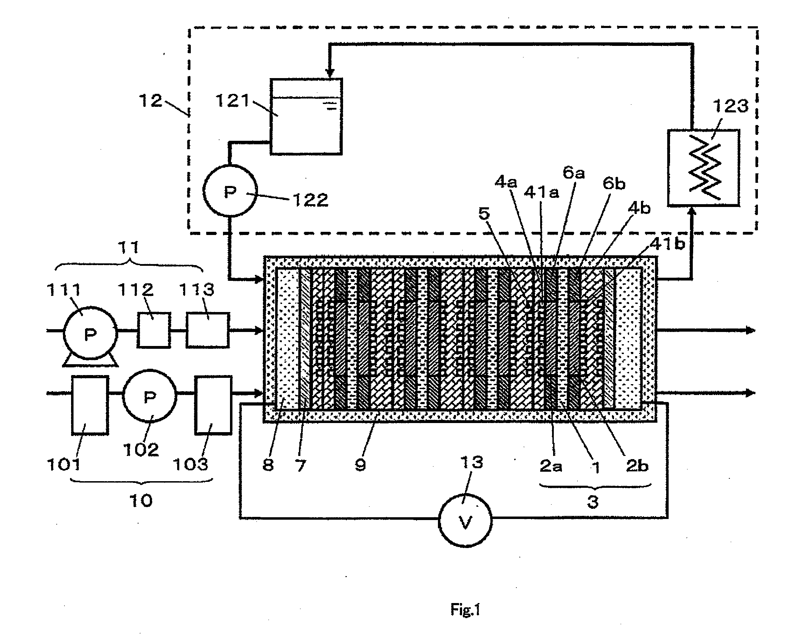

Fig. 1 is a schematic configuration diagram showing a fuel cell power generation system in Embodiment 1 of the present invention.

As shown in Fig. 1, the fuel cell power generation system of Embodiment 1 of the present invention includes fuel cells 3. Each of the fuel cells 3 is formed such that an anode 2a and a cathode 2b are respectively disposed on both surfaces of a polymer electrolyte 1 so as to be opposed to each other.

Here, the polymer electrolyte 1 is constituted by, for example, a solid polymer electrolyte made of a perfluorocarbon sulfonic acid polymer having hydrogen ion conductivity.

Each of the anode 2a and the cathode 2b is constituted by a catalyst layer and a gas diffusion layer stacked on the catalyst layer. The catalyst layer is formed by a mixture of a catalyst and a polymer electrolyte having hydrogen ion conductivity. The catalyst is prepared such that porous carbon having high oxidation resistance supports precious metal, such as platinum. The gas diffusion layer has gas permeability and electron conductivity.

Typically used as the catalyst of the anode 2a is a platinum-ruthenium alloy catalyst which suppresses poisoning by impurities, especially carbon monoxide, contained in the fuel gas. Moreover, used as the gas diffusion layer is carbon paper or carbon cloth subjected to water repellent finish, carbon nonwoven fabric, or the like.

Then, an anode separator 4a and a cathode separator 4b are disposed so as to sandwich the fuel cell 3 and be opposed to each other. A fuel gas channel 41a through which the fuel gas is supplied and discharged is formed on a surface of the anode separator 4a, the surface being located on the fuel cell 3 side. An oxidizing gas channel 41b through which the oxidizing gas is supplied and discharged is formed on a surface of the cathode separator 4b, the surface being located on the fuel cell 3 side.

Further, a cooling fluid channel 5 through which a cooling fluid for cooling the fuel cell 3 is supplied and discharged is formed on a surface of the cathode separator 4b, the surface being opposite to the above surface located on the fuel cell 3 side. Here, the cooling fluid channel 5 may be formed on a surface of the anode separator 4a, the surface being opposite to the above surface located on the fuel cell 3 side, or a separate cooling plate on which the cooling fluid channel 5 is formed may be separately provided.

Here, each of the anode separator 4a and the cathode separator 4b is formed mainly by a material, such as carbon, having electrical conductivity.

Then, the anode separator 4a and the fuel cell 3 are sealed by an anode gasket 6a and the cathode separator 4b and the fuel cell 3 are sealed by a cathode gasket 6b to prevent each of the fluids in the channels from leaking to the other channel or to the outside.

Then, a plurality of cells each formed by the fuel cell 3 and the separators 4a and 4b are stacked on one another. To take out a current, current collectors 7 are respectively disposed on both sides of the assembly of the plurality of cells. Further, end plates 8 are respectively disposed on the current collectors via insulators (not shown), and these members are fastened. Thus, the stack is formed. A heat insulator 9 is disposed around the stack to prevent heat release to the outside and improve exhaust heat recovery efficiency.

Moreover, a fuel gas supply mechanism 10, an oxidizing gas supply mechanism 11, and a cooling mechanism 12 are connected to the stack. The fuel gas supply mechanism 10 is configured to supply the fuel gas containing hydrogen to the anode 2a side. The oxidizing gas supply mechanism 11 is configured to supply the oxidizing gas containing oxygen in the atmosphere to the cathode 2b. The cooling mechanism 12 is configured to supply the cooling fluid for cooling the stack and performing heat exchange with the heat generated by the stack.

Here, the fuel gas supply mechanism 10 includes: a desulfurizer 101 configured to remove a sulfur compound that is a catalyst poison from a material gas, such as a city gas (natural gas); a material gas supply unit 102 configured to control the flow rate of the desulfurized material gas; and a fuel processor 103 configured to reform the desulfurized material gas to generate hydrogen.

Further, the fuel processor 103 includes a reformer (not shown) configured to generate a hydrogen-containing reformed gas by a reforming reaction using the material gas and water. The fuel processor 103 may include a carbon monoxide shift converter and a carbon monoxide remover, each configured to decrease carbon monoxide in the reformed gas generated by the reformer.

Here, for example, in a case where methane is used as the material gas, reactions represented by Chemical Formulas 1 and 2 occur with the steam in the reformer, and the hydrogen is generated.

**Chemical Formula 1**  $\quad CH_4 + H_2O \rightarrow CO + 3H_2$

**Chemical Formula 2**  $\quad CO + H_2O \rightarrow CO_2 + H_2$

Chemical Formula 3 is obtained by combining all the reactions in the reformer.

$$\text{Chemical Formula 3} \qquad CH_4 + 2H_2O \rightarrow CO_2 + 4H_2$$

However, the reformed gas generated in the reformer contains about 10% carbon monoxide in addition to the hydrogen. Then, in an operating temperature range of the fuel cell 3, the carbon monoxide poisons the catalyst contained in the anode 2a and decreases the catalytic activity of the catalyst. Here, as represented by a reaction formula that is Chemical Formula 2, the carbon monoxide generated by the reformer is converted into carbon dioxide by the carbon monoxide shift converter. With this, the concentration of the carbon monoxide is decreased to about 5,000 ppm.

Further, the carbon monoxide, the concentration of which has been decreased, is selectively oxidized by the carbon monoxide remover using oxygen taken in from the atmosphere or the like, in accordance with a reaction represented by Chemical Formula 4. With this, the concentration of the carbon monoxide is decreased to about 10 ppm or lower, by which the catalytic activity of the catalyst of the anode 2a can be prevented from decreasing.

Thus, the fuel processor 103 generates the fuel gas in which the concentration of the carbon monoxide is adequately decreased. Then, the fuel processor 103 supplies the fuel gas to the anode 2a of the fuel cell 3. In Embodiment 1, in a case where a fuel cell, such as a phosphoric-acid fuel cell, which is hardly influenced by the carbon monoxide is used as the fuel cell 3, the fuel processor 103 may be configured not to include the carbon monoxide shift converter and the carbon monoxide remover.

$$\text{Chemical Formula 4} \qquad CO + FehlerO_2 \rightarrow CO_2$$

Moreover, an air bleed supply unit configured to supply air to the anode 2a during the electric power generation is provided in the fuel cell power generation system to mix about 1 to 2% air in the fuel gas generated by the fuel processor 103. With this, the carbon monoxide slightly remaining in the fuel gas is oxidized in the anode 2a to be converted into the carbon dioxide. Thus, the influence of the carbon monoxide can be further decreased.

The fuel gas supply mechanism 10 is not limited to the above steam reforming, and a hydrogen generating method, such as autothermal reforming, may be used. Moreover, in a case where the concentration of the carbon monoxide contained in the fuel gas is low, the air bleed supply unit can be omitted.

Then, the oxidizing gas supply mechanism 11 includes: an oxidizing gas flow rate controller 111 configured to control the flow rate of the oxidizing gas; an impurity remover 112 configured to remove the impurities in the oxidizing gas to some extent; and a humidifier 113 configured to humidify the oxidizing gas.

Here, the oxidizing gas denotes a gas containing at least oxygen (or a gas capable of supplying oxygen). For example, atmosphere (air) is utilized.

Further, the impurity remover 112 includes: a dust removing filter configured to remove dusts in the atmosphere; an acid gas removing filter configured to remove sulfur impurities, such as sulfur dioxide and hydrogen sulfide, and acid gases, such as nitrogen oxide, in the atmosphere; and an alkaline gas removing filter configured to remove alkaline gases, such as ammonia, in the atmosphere. In the impurity remover 112, each of these filters may be omitted depending on an installation environment, contamination resistance of the fuel cell 3, and the like.

The cooling mechanism 12 includes: a cooling fluid tank 121 configured to store the cooling fluid for cooling the stack; a cooling fluid pump 122 configured to supply the cooling fluid; and a heat exchanger 123 configured to perform heat exchange with the cooling fluid, which has flowed through the cooling fluid channel 5 and performed heat exchange with the heat generated in the fuel cell 3, to produce hot water.

Moreover, a voltage detector 13 configured to detect a battery voltage of the stack is provided for the stack.

Then, an oxidizing gas supply valve (not shown) is disposed on a pipe (oxidizing gas supply passage) connecting the oxidizing gas supply mechanism 11 and the fuel cell 3. Moreover, a pipe (oxidizing gas discharge passage) through which a gas, such as the oxidizing gas, unconsumed in the cathode 2b is discharged is connected to the fuel cell 3. An oxidizing gas discharge valve (not shown) is disposed on the oxidizing gas discharge passage.

With this configuration, the oxygen getting into the cathode 2b from the outside is blocked by closing the oxidizing gas supply valve and the oxidizing gas discharge valve during the stop of the electric power generation of the fuel cell 3. Thus, the concentration of the oxygen in the cathode 2b decreases quickly, and the electrode potential of the cathode 2b decreases rapidly and is maintained at a low potential. Therefore, the catalyst of the cathode 2b can be efficiently reduced and activated.

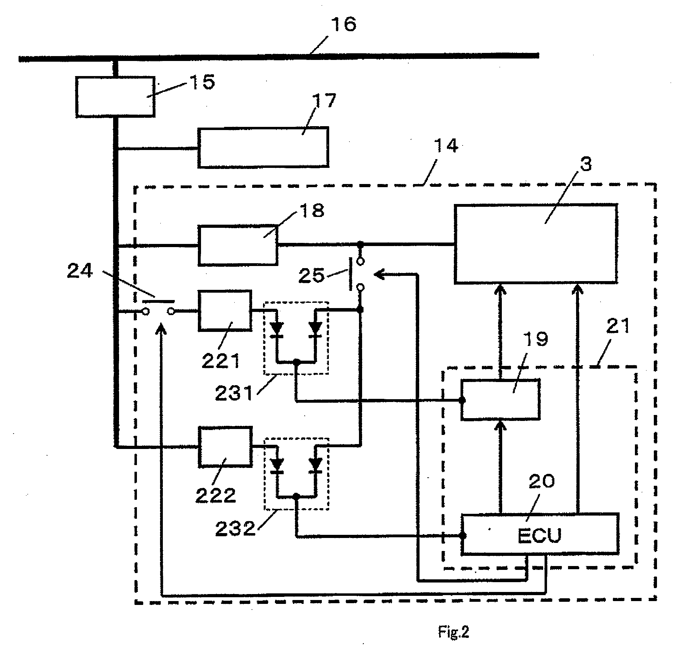

Next, the configuration of an electric circuit of the fuel cell power generation system of Embodiment 1 of the present invention will be explained in reference to a circuit configuration diagram of Fig. 2.

In Fig. 2, a fuel cell power generation system 14 is connected to a commercial power supply 16 via a distribution board 15 provided at home. Moreover, an external load 17 that is a device used at home is connected to between the distribution board 15 and the fuel cell power generation system 14. When the fuel cell power generation system 14 is not generating the electric power, AC power of the external load 17 is supplied from the commercial power supply 16.

When the fuel cell power generation system 14 is generating the electric power, the AC power of the external load 17 is supplied from the fuel cell power generation system 14, and shortage is supplied from the commercial power supply 16.

DC power generated by the fuel cell 3 is converted into AC power by an electric power output unit 18, such as an inverter. Thus, the AC power can be supplied to the external load 17. The output of the electric power output unit 18 can be controlled from 0 to 100%. The electric power output unit 18 may be, for example, a DC/DC converter and supply the DC power to the external load 17.

At the time of the start-up, the stop, or the like, in which the fuel cell 3 is not generating the electric power, the electric power necessary to operate the fuel cell 3 is supplied from the commercial power supply 16. Moreover, when the fuel cell 3 is generating the electric power, the electric power necessary to operate the fuel cell 3 is supplied from the fuel cell 3 through the DC/DC converter. The electric power necessary to operate the fuel cell 3 is a drive power supply and control power supply of an internal load 21 constituted by auxiliary devices 19, a controller 20, and the like. Examples of the auxiliary devices 19 are a pump, a fan, a solenoid valve, and a heater provided in the fuel cell power generation system 14.

Moreover, AC/DC converters 221 and 222 supply the electric power from the commercial power supply 16 to the auxiliary device 19 and the controller 20, respectively. Each of power supply switching portions 231 and 232 switches an electric power supply source of the auxiliary device 19 or the controller 20 between the commercial power supply 16 and the fuel cell 3.

Moreover, the controller 20 can control the start-up operation, electric power generation, and stop operation of the fuel cell 3 and also control the operations of the cooling mechanism 12, the internal load 21, and the electric power output unit 18. Moreover, the controller 20 may be any device as long as it controls respective devices constituting the fuel cell power generation system. For example, the controller 20 includes a calculation processing portion, such as a microprocessor or a CPU, and a storage portion, such as a memory, storing programs for executing respective control operations. The controller 20 may be constituted by one controller or a group of a plurality of controllers which cooperate to execute control operations of the fuel cell power generation system. Moreover, the controller 20 may be constituted by a microcontroller. Further, the controller 20 may be constituted by a MPU, a PLC (programmable logic controller), a logic circuit, or the like.

**Operations of Fuel Cell Power Generation System**

Next, the operations of the above fuel cell power generation system during the electric power generation will be explained in reference to Figs. 1 and 2. The following operations are carried out such that the controller 20 controls respective devices constituting the fuel cell power generation system.

First, in Fig. 1, the fuel gas is supplied to the anode 2a, the oxidizing gas is supplied to the cathode 2b, and a load is connected to the fuel cell 3. In this case, as shown by a reaction formula (Chemical Formula 5), hydrogen in the fuel gas emits electrons at an interface between the catalyst layer of the anode 2a and the polymer electrolyte 1 to become hydrogen ions.

$$\text{Chemical Formula 5} \qquad H_2 \rightarrow 2H^+ + 2e\text{-}$$

Then, the emitted hydrogen ions move through the polymer electrolyte 1 to the cathode 2b to receive the electrons at an interface between the catalyst layer of the cathode 2b and the polymer electrolyte 1. At this time, the hydrogen ions react with oxygen in the oxidizing gas supplied to the cathode 2b to generate water as shown by a reaction formula (Chemical Formula 6).

$$\text{Chemical Formula 6} \qquad Fehler_O2 + 2H^+ + 2e^- \rightarrow H_2O$$

Chemical Formula 7 is obtained by combining the above reactions.

$$\text{Chemical Formula 7} \qquad H_2 + FehlerO_2 \rightarrow H_2O$$

Then, the flow of the electrons flowing through the load can be utilized as electric energy. Moreover, the above reactions are exothermic reactions. Therefore, the heat generated by the fuel cell 3 is recovered by the heat exchange using the cooling fluid supplied from the cooling fluid channel 5, and the recovered heat can be utilized as the heat energy for hot water and the like.

Here, the atmosphere existing at the installation environment is generally used as the oxidizing gas used for the electric power generation of the fuel cell 3. However, the atmosphere often contains various impurities. Examples of the impurities are sulfur compounds, such as sulfur dioxide, contained in volcanoes, flue gases, and the like, nitrogen oxide contained much in flue gases of factories and automobiles, and ammonia that is a malodorous component.

Here, although the impurity remover 112 can remove most of the impurities, it may not be able to keep on removing all the impurities for a long period of time. Especially, in a case where, for example, the impurity concentration at the installation environment is high, or the amount of catalyst of the fuel cell 3 is small, the impurities may be accumulated in the cathode 2b, and this may deteriorate the power generation efficiency and durability of the fuel cell 3.

These impurities negatively influence the fuel cell 3. The impurities may get mixed in with the oxidizing gas, be adsorbed to the catalyst of the cathode 2b, interfere with the chemical reaction necessary for the electric power generation, and deteriorate the output of the fuel cell 3. Especially, adsorption force of the sulfur compound is comparatively high. If a large amount of sulfur compounds are accumulated in the cathode 2b, it becomes difficult to remove the sulfur compounds. This becomes a cause of the deterioration of the power generation efficiency and durability of the fuel cell 3.

The present inventors have focused on and diligently studied the sulfur compound which comparatively significantly influences the electric power generating performance. As a result, the present inventors have found the following. That is, after the first step of oxidizing the sulfur compound adhered to the cathode 2b such that the sulfur compound becomes less likely to adhere to the cathode 2b, the second step of condensing the steam existing in the stack, dissolving in the condensed water the impurities oxidized in the first step to remove the impurities from the catalyst of the cathode 2b, and stopping the supply of the oxidizing gas is carried out. With this, the electrode potential of the cathode 2b from which the impurities are removed decreases, and the catalyst is reduced. Therefore, the catalyst of the cathode 2b can be adequately activated as compared to a case where the sulfur compound adhered to the cathode 2b is just oxidized and washed away by the condensed water.

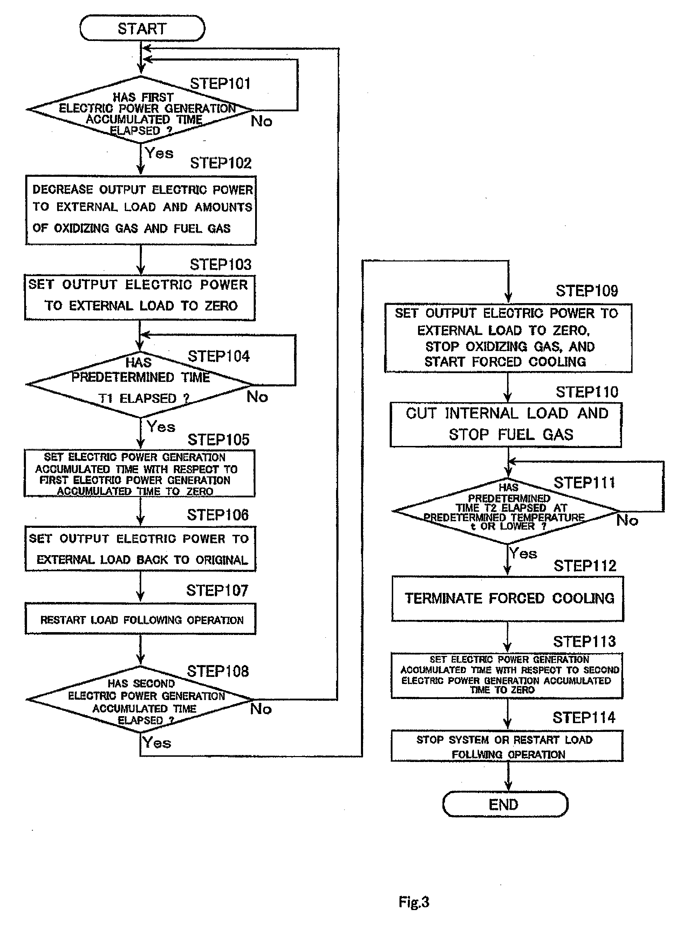

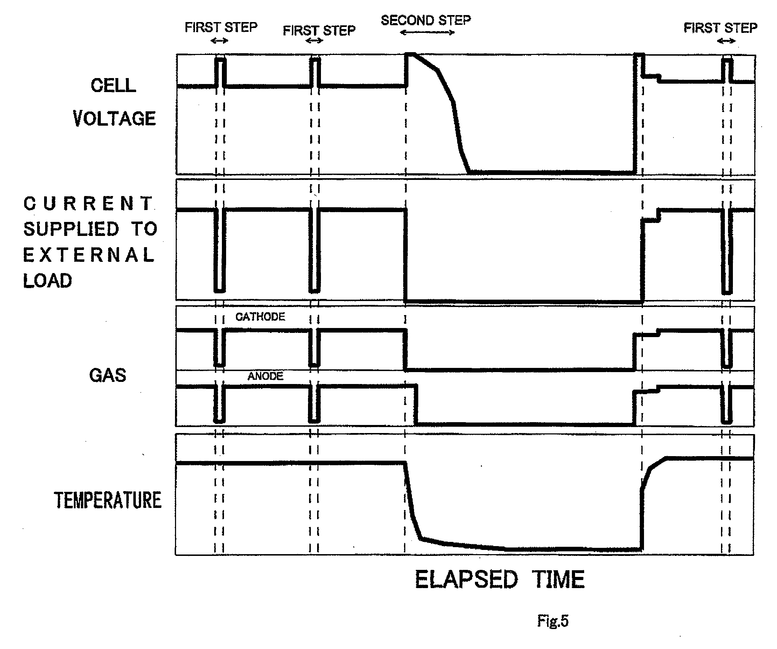

Hereinafter, an operation sequence of the fuel cell power generation system capable of suppressing the decrease in the catalytic activity by the impurity that is, as an example, sulfur dioxide contained in the atmosphere among the sulfur compounds will be explained in reference to the flow chart of Fig. 3 and the time chart of Fig. 5.

Fig. 3 is a time chart showing an operating sequence of the fuel cell power generation system in Embodiment 1 shown in Fig. 1. Fig. 5 is a flow chart showing the operating sequence of the fuel cell power generation system in Embodiment 1 shown in Fig. 1.

First, as shown in Fig. 3, the controller 20 obtains the accumulated time of the electric power generation of the fuel cell 3. When the accumulated time passes a first electric power generation accumulated time (Yes in Step 101), the controller 20 executes the first step. Specifically, the controller 20 carries out control operations as follows.

As shown in Fig. 5, the controller 20 controls the electric power output unit 18 to stop a load following operation of the fuel cell 3 and forcibly decrease output electric power to the external load 17 and decreases the operation amounts of the auxiliary devices 19 (the fuel gas supply mechanism 10 and the oxidizing gas supply mechanism 11) to decrease the supply amounts of the fuel gas and the oxidizing gas (Step 102).

Here, in a case where the average concentration of the impurity in the oxidizing gas containing the sulfur dioxide is substantially constant, the amount of impurity accumulated in the catalyst of the cathode can be calculated from the amount of oxidizing gas supplied to the cathode of the fuel cell. The first electric power generation accumulated time is, for example, a time in which an accumulated supply amount obtained by accumulating the amount of oxidizing gas supplied to the fuel cell 3 by the oxidizing gas supply mechanism 11 reaches a predetermined threshold 11 (first accumulated supply amount). Although it depends on conditions, the first electric power generation accumulated time is from about several hours (for example, two or three hours) to several tens of hours (for example, 20 or 30 hours). A first accumulated supply amount $I_1$ can be represented by Formula 1 below using a concentration c of sulfur dioxide in the oxidizing gas (atmosphere) and a lowest removal rate r of the impurity remover 112 of the oxidizing gas supply mechanism 11.

**Formula 1**

$$I_1 = \text{Fehler!}$$

Here, $e_1$ denotes the amount of exposure to sulfur dioxide when a decreased voltage of an electric power generation voltage of the fuel cell 3 reaches a preset threshold, the electric power generation voltage being decreased by the sulfur dioxide contained in the oxidizing gas as the impurity. Since the relation between the amount of exposure to sulfur dioxide and the decreased voltage of the fuel cell 3 differs depending on conditions, it has to be experimentally measured in advance. In Embodiment 1, the first electric power generation accumulated time is set to the time in which the accumulated supply amount reaches the first accumulated supply amount obtained by accumulating the amount of oxidizing gas supplied. However, the present embodiment is not limited to this. For example, a time in which the accumulated supply amount becomes the first accumulated supply amount or larger may be pre-calculated by experiments or the like, and the obtained time may be used as the first electric power generation accumulated time.

With this, before the output electric power of the electric power output unit 18 to the external load 17 is set to zero, the amount of consumption of each of the fuel gas and oxidizing gas which do not contribute to the electric power output to the outside is decreased. Thus, the operation amounts of the fuel gas supply mechanism 10 and the oxidizing gas supply mechanism 11 can be decreased, and the power consumption can be suppressed. Further, since the amount of change in the flow rate of the off gas from the anode 2a of the fuel cell 3 is minimized, the stability of the fuel gas supply mechanism 10 can be maintained.

Next, the controller 20 causes the electric power output unit 18 to supply the DC power to the internal load 21 and sets the output electric power of the electric power output unit 18 to the external load 17 to zero (Step 103). With this, the electrode potential of the cathode 2b increases to a first voltage or higher. Then, the controller 20 maintains this state until a predetermined time T1 necessary to oxidize the impurity, such as sulfur dioxide, adhered to the cathode 2b elapses.

Here, the first voltage or higher denotes a range from substantially 0.85 to 1.0 V. Since the electrode potential of the cathode 2b increases such that the voltage of the unit cell becomes up to 0.85 to 1.0 V the sulfur dioxide adsorbed to the cathode 2b can be oxidized. Since the internal load 21 consumes the electric power, the potential of the cathode 2b becomes lower than the natural potential (open circuit voltage). Therefore, the deterioration of the polymer electrolyte 1 and the carbon in the catalyst layer can be suppressed.

Moreover, the present inventors have confirmed that the predetermined time T1 does not have to be a long period of time, and the effects are achieved when the predetermined time T1 is from about several seconds (for example, two or three seconds) to several tens of seconds (for example, 20 or 30 seconds). Therefore, the fuel gas and oxidizing gas which do not contribute to the electric power generation for the outside and the electric power consumed to supply these gases can be minimized. Moreover, the stop time of the electric power generation of the fuel cell 3 is suppressed to a short period of time, and the electric power generation can be restarted immediately. Therefore, the thermal balance of, for example, the fuel gas supply mechanism 10 to which the off gas of the fuel gas is supplied does not fluctuate, and the stable electric power generation can be continued.

Further, in Step 103, the controller 20 turns on a relay 24 configured to block the commercial power supply 16, switches the power supply of the auxiliary device 19 in the internal load 21 to the commercial power supply 16 by the power supply switching portion 231, and maintains the fuel cell 3 as the power supply of the controller 20. With this, the internal load 21 can be decreased, the electrode potential of the cathode 2b can be further increased, and a larger amount of sulfur dioxide can be oxidized.

Next, when the predetermined time has elapsed (Yes in Step 104), the controller 20 sets the accumulated time of the electric power generation of the fuel cell 3 with respect to the first electric power generation accumulated time to zero (Step 105). To be specific, the controller 20 sets the electric power generation accumulated time, stored in a storage portion, of the fuel cell 3 with respect to the first electric power generation accumulated time to zero. Next, the controller 20 sets the output electric power of the electric power output unit 18 to the external load 17 back to the same output as in Step 102 once (Step 106), and then restarts the load following operation of the fuel cell 3 (Step 107). These operations are carried out as the first step.

As above, in Embodiment 1, in an extremely short period of time for executing the first step each time the accumulated time reaches the first electric power generation accumulated time during the electric power generation of the fuel cell 3, the electrode potential of the cathode 2b is temporarily increased without stopping the fuel cell power generation system, and the impurity adhered to the cathode 2b is oxidized. Thus, the binding force between the catalyst of the cathode 2b and the impurity (sulfur compound) can be weakened, and the impurity can be easily desorbed from the catalyst of the cathode 2b.

Next, the second step will be explained. As shown in Fig. 3, when the electric power generation accumulated time of the fuel cell 3 exceeds a second electric power generation accumulated time (Yes in Step 108), the controller 20 causes the electric power output unit 18 to set the electric power to the external load 17 to zero, and in addition, the controller 20 causes the oxidizing gas supply mechanism 11 to stop supplying the oxidizing gas and causes the cooling fluid pump 122 of the cooling mechanism 12 to increase the recovery of the heat generated in the fuel cell 3 and forcibly start cooling the fuel cell 3 (Step 109).

At this time, since the internal load 21 of the fuel cell 3 is still connected to the fuel cell 3, the oxygen remaining in the cathode 2b is consumed, and the potential of the cathode 2b decreases. The cooling fluid having recovered the heat of the fuel cell 3 performs the heat exchange with a fluid (such as water in a hot water tank or city water) having a lower temperature than the cooling fluid by the heat exchanger 123. Thus, the cooling fluid decreases in temperature and circulates.

With this, each time the accumulated time reaches the second electric power generation accumulated time longer than the first electric power generation accumulated time, the steam in the stack is condensed, and the impurity, such as oxidized sulfur dioxide, desorbed by increasing the electrode potential of the cathode 2b in the first step is washed away. Moreover, the electrode potential of the cathode 2b is decreased by stopping the supply of the oxidizing gas. Thus, the catalyst can be reduced and activated. Moreover, the stop time of the electric power generation can be shortened by forcibly cooling the fuel cell 3. On this account, it is possible to suppress the temperature decrease of the fuel processor 103 of the fuel gas supply mechanism 10 by the stop of the electric power generation of the fuel cell 3.

Moreover, it is possible to decrease the energy and time necessary to increase the temperature of the fuel processor 103 when restarting the electric power generation of the fuel cell 3 after the second step. Further, the stability of the fuel gas supply mechanism 10 can be improved.

Therefore, the electric power generation is hardly stopped except for an extremely short period of time in which the electric power generation of the fuel cell 3 is stopped in the second step, and the influence of the impurity on the electric power generation can be eased. On this account, it is possible to obtain the fuel cell power generation system which can operate for a long period of time, can decrease the number of start-up and stop operations, can suppress the energy consumed by the start-up and stop operations, and excels in overall efficiency.

Moreover, in the second step, the electric power generated by the fuel cell 3 is supplied only to the internal load 21. With this, the heat generated by the fuel cell 3 is significantly decreased. On this account, the temperature decrease of the fuel cell 3 during the supply of the electric power to the external load 17 is suppressed. Moreover, the amount of water generated is decreased since the amount of electric power generated is extremely small. Thus, the voltage decrease by flooding can be suppressed.

Here, the second electric power generation accumulated time is, for example, a time in which a second accumulated supply amount larger than the first accumulated supply amount obtained by accumulating the amount of oxidizing gas supplied to the fuel cell 3 by the oxidizing gas supply mechanism 11 reaches a predetermined threshold 12. The second electric power generation accumulated time is longer than the first electric power generation accumulated time. Although it depends on conditions, the second electric power generation accumulated time is from about several days to several tens of days, and for example, three days, a week, a month, two months, or the like.

Here, in a case where the average concentration of the impurity in the oxidizing gas is substantially constant, the amount of impurity accumulated in the catalyst of the cathode can be calculated from the amount of oxidizing gas supplied to the cathode of the fuel cell. A second accumulated supply amount $I_2$ can be represented by Formula 2 below using the concentration c of sulfur dioxide in the oxidizing gas and the lowest removal rate r of the impurity remover 112 of the oxidizing gas supply mechanism 11.

$$[0115] \quad \textbf{Formula 2}$$

$$I_2 = \textbf{Fehler!}$$

Here, e2 denotes the amount of exposure to sulfur dioxide which is removed by one stop operation of the electric power generation of the fuel cell power generation system after the first step. The first step is a step performed each time the accumulated time reaches the first electric power generation accumulated time and is a step in which the sulfur dioxide which is contained in the oxidizing gas as the impurity and decreases the electric power generation voltage of the fuel cell 3 is oxidized. Whether the sulfur dioxide has been removed or not can be determined by determining whether the electric power generation voltage of the fuel cell 3 after the removal of the sulfur dioxide is the same level as the voltage before the voltage decrease or not. That is, whether the sulfur dioxide has been removed or not can be determined by determining whether the decreased voltage which may be decreased by the sulfur dioxide is substantially recovered or not. Since the relation between the decreased voltage recovered by one start-up operation and one stop operation of the fuel cell power generation system and the amount of exposure to sulfur dioxide differs depending on conditions, it has to be experimentally measured in advance. In Embodiment 1, the second accumulated supply amount is used to obtain the second electric power generation accumulated time, but the present embodiment is not limited to this. For example, a time in which the accumulated supply amount becomes the second accumulated supply amount or larger may be pre-calculated by experiments or the like, and the obtained time maybe used as the second electric power generation accumulated time.

Next, the controller 20 opens a relay (second relay) 25 configured to block the DC power of the fuel cell 3 to electrically separate the internal load 21 from the fuel cell 3 and stops the supply of the fuel gas (Step 110). The auxiliary devices, such as the cooling mechanism 12, in the internal load 21 have to operate even when the internal load 21 is separated from the fuel cell 3. Therefore, the electric power supply source for the auxiliary devices needs to be switched in advance to the commercial power supply 16 by the power supply switching portion 231 such that the auxiliary devices can operate by the commercial power supply 16.

Next, when a predetermined time T2 has elapsed since the decrease in temperature of the fuel cell 3 up to a predetermined temperature t or lower (Yes in Step 111), the controller 20 stops the cooling mechanism 12 to stop forced cooling of the fuel cell 3 (Step 112).

Here, the predetermined temperature t when cooling the fuel cell 3 is the temperature of the fuel cell 3 (or the temperature of the cooling fluid) at which the amount of condensed water necessary to wash away and remove the sulfur dioxide accumulated in the cathode 2b can be obtained. The predetermined temperature t varies depending on a temperature condition of the fuel cell 3 during the electric power generation and a humidification condition. The lower the predetermined temperature t is, the larger the mount of condensed water becomes. Therefore, it is preferable that the predetermined temperature t be low. The present inventors have found that the effects can be adequately achieved by decreasing the temperature of the fuel cell 3 such that the temperature of the fuel cell 3 when cooled is lower than the temperature of the fuel cell 3 during the electric power generation by about 10°C to several tens of degrees centigrade, such as 10°C to 20°C.

Moreover, it is preferable that the predetermined time T2 in which the predetermined temperature when cooling the fuel cell 3 continues be from about several tens of minutes (for example, 20 or 30 minutes) to several hours (for example, one or two hours). Within the predetermined time T2, the sulfur dioxide can be dissolved in the condensed water to be desorbed from the cathode 2b.

Next, the controller 20 sets the accumulated time of the electric power generation of the fuel cell 3 with respect to the second electric power generation accumulated time to zero (Step 113). To be specific, the controller 20 sets the electric power generation accumulated time, stored in the storage portion, of the fuel cell 3 with respect to the second electric power generation accumulated time to zero. Thus, the controller 20 performs the second step.

Next, after the termination of the second step (to be specific, after the termination of Step 113), the controller 20 restarts the electric power generation of the fuel cell 3 and restarts the load following operation of the fuel cell 3 (Step 114). In Fig. 5, the controller 20 stops the operation of the fuel cell power generation system after the termination of the second step. As above in Embodiment 1, the first step and the second step are carried out in the middle of the electric power generating operation of the fuel cell power generation system. However, the present embodiment is not limited to this. For example, the first step may be carried out when stopping the operation of the fuel cell power generation system for the first time after the first electric power generation accumulated time elapses, and/or the second step may be carried out when stopping the operation of the fuel cell power generation system for the first time after the second electric power generation accumulated time elapses.

As above, in the second step, the fuel cell 3 is forcibly cooled in a short period of time by using the cooling mechanism 12. With this, the amount of condensed water can be increased in a short period of time, and a larger amount of impurities can be removed. Moreover, since the time for cooling can be shortened, the time for the second process can be shortened, and the stop time of the electric power generation of the fuel cell 3 can be shortened.

On this account, it is possible to improve the start-up property and stability of the fuel gas supply mechanism 10 and the like when immediately restarting the electric power generation next time. To be specific, the stop time of the electric power generation of the fuel cell 3 is shortened, and the time until the restart of the electric power generation is shortened. With this, the temperature of the fuel gas supply mechanism 10 can be maintained at high temperature. Therefore, the energy and time consumed to increase the temperature of the fuel gas supply mechanism 10 at the time of the next start-up can be saved, and the amount of condensed water in the fuel gas supply mechanism 10 at the time of the stop of the electric power generation can be decreased. Therefore, it is possible to suppress the interference of the catalyst reaction by the water condensed on the catalyst of the fuel gas supply mechanism 10 at the time of the restart of the electric power generation. Thus, the start-up property and stability of the fuel gas supply mechanism 10 can be improved.

**Test Example**

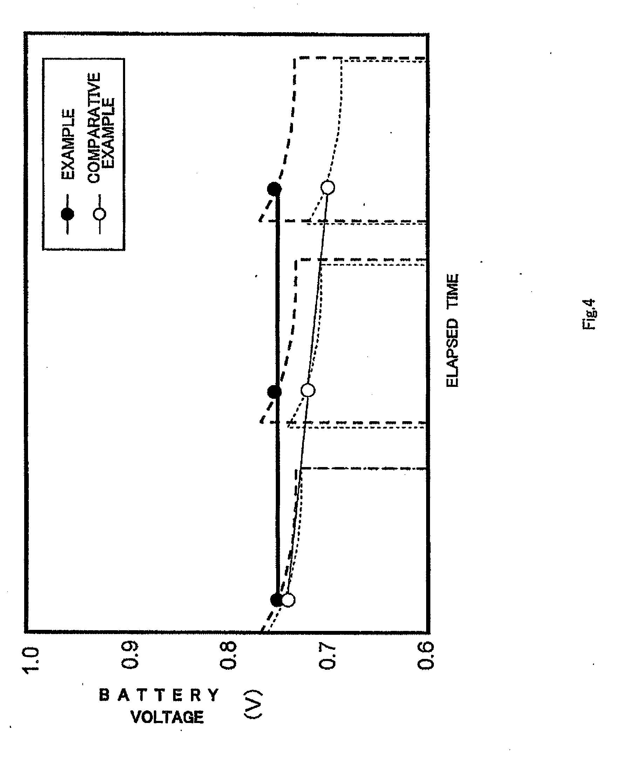

Next, evaluations of voltage behaviors during the electric power generation using the fuel cell power generation system and operating sequence in Embodiment 1 in a case where the sulfur dioxide actually exists in the oxidizing gas are carried out. Moreover, for comparison, evaluations of the voltage behaviors in a case where the electrode potential is not increased (to be specific, the first step is not carried out) and the sulfur dioxide is not oxidized are carried out. Results of these evaluations are shown in Fig. 4.

In this evaluation test, the fuel cell power generation system shown in Figs. 1 and 2 is constructed. The utilization ratio and dew point of the fuel gas supplied to the anode 2a side are respectively 70% and about 55°C, and the utilization ratio and dew point of the oxidizing gas supplied to the cathode 2b side are respectively 50% and about 65°C. Then, the load is controlled such that the current density with respect to the electrode area of each of the anode 2a and the cathode 2b becomes 0.2 A/cm$^2$. With this, the current flows constantly. Moreover, the flow rate of the cooling fluid for cooling the fuel cell 3 is controlled such that the temperature of the cooling fluid becomes about 60°C in the vicinity of a fuel cell cooling fluid channel entrance manifold (an end of a channel (pipe) through which the cooling fluid flows, the end being located on an entrance side of the fuel cell 3) and about 70°C in the vicinity of a fuel cell cooling fluid channel exit manifold (an end of the channel (pipe) through which the cooling fluid flows, the end being located on an exit side of the fuel cell 3).

Then, the oxidizing gas containing about 8 ppb sulfur dioxide is supplied.

Then, as Example, each time the accumulated time reaches the first electric power generation accumulated time (about ten hours), the DC power is supplied to the internal load 21, and the output of the electric power output unit 18 (herein, an inverter) is set to zero for a predetermined time (about ten seconds) to increase the electrode potential of the cathode 2b. At this time, the electric power to the auxiliary device 19 in the internal load 21 is supplied from the commercial power supply 16. Therefore, the output of the DC power of the fuel cell at this time is from about several watts to several tens of watts, and the battery voltage of the fuel cell 3 is increased to about 0.9 to 1.0 V

Here, immediately before setting the output of the electric power output unit 18 to zero, the output of the electric power output unit 18 is decreased once until the current density becomes about 0.06 A/cm$^2$. Then, the flow rates of the fuel gas and oxidizing gas respectively supplied to the anode 2a and the cathode 2b are also decreased.

In contrast, in Comparative Example, even when the first electric power generation accumulated time has elapsed, the output of the electric power output unit 18 is not changed, and the electrode potential of the cathode 2b is not increased.

Further, each time the accumulated time reaches the second electric power generation accumulated time (about ten days), the electric power generation of the fuel cell 3 is stopped, the fuel cell 3 is forcibly cooled to 50°C, the condensed water is generated in the fuel cell 3, and sulfur trioxide that is oxidized sulfur dioxide is dissolved in the water to be washed away.

Then, this electric power generation and stop are repeatedly carried out, and the inclination (decay rate) of the battery voltage is examined. Fig. 4 shows temporal change of the battery voltage per unit cell.

In Fig. 4, a thin dotted line shows the behavior of the battery voltage in a case where the electrode potential is not increased periodically in Comparative Example. White circles and a thin solid line show changes in the battery voltage value after a certain time has elapsed since the start of the electric power generation. It is found from Fig. 4 that the decay rate of the battery voltage in Comparative Example is high, and the battery voltage decreases with time.

In Fig. 4, a thick dotted line shows the behavior of the battery voltage in Example. Black circles and a thick solid line show changes in the battery voltage value after a certain time has elapsed since the start of the electric power generation. It is found from Fig. 4 that in accordance with the configuration and operating sequence of the fuel cell power generation system of Embodiment 1, the battery voltage is substantially constant, and the battery voltage decreases little.

**Operational Advantages of Fuel Cell Power Generation System**

As above, in accordance with the fuel cell power generation system of Embodiment 1, the impurity which decreases the catalytic activity of the cathode 2b can be removed, and the catalyst can be adequately activated. Even when the fuel cell power generation system continuously operates for a long period of time, the voltage decrease of the fuel cell 3 does not accumulate, and high power generation efficiency can be maintained for a long period of time. Thus, it is possible to realize the fuel cell power generation system which excels in the power generation efficiency and durability.

Moreover, in the fuel cell power generation system of Embodiment 1, all the loads of the fuel cell 3 are not separated to remove the impurity, and the supply of the electric power to the external load 17 is just stopped while consuming a part of the DC power by the internal load 21. Therefore, without activating the relay 25 configured to cut all the loads of the fuel cell 3, the electrode potential of the cathode 2b can be increased, and the number of open and close operations of the relay 25 does not increase. Thus, high durability of the fuel cell power generation system can be maintained.

Further, in the fuel cell power generation system of Embodiment 1, since the electric power generated in the fuel cell 3 is consumed by the internal load 21 in the second step, the electrode potential of the cathode 2b can be decreased quickly without any deterioration, such as polarity inversion, and the catalyst of the cathode 2b can be efficiently reduced and activated in a short period of time without stopping the electric power generation. Therefore, the fuel cell power generation system can continuously operate for a long period of time, the number of start-up and stop operations can be decreased, and the energy consumed by the start-up and stop operations can be suppressed. Thus, it is possible to obtain the fuel cell power generation system which excels in overall efficiency.

In Embodiment 1, in the first step, the supply of the electric power to the external load 17 is stopped by the electric power output unit 18. However, the present embodiment is not limited to this. For example, the supply of the electric power to the external load 17 may be stopped by opening a relay (first relay) disposed on a wire electrically connecting the electric power output unit 18 and the external load 17.

Moreover, in Embodiment 1, in the second step, the supply of the electric power to the internal load 21 is stopped by opening the relay 25. However, the present embodiment is not limited to this. For example, the electric power output unit 18 may stop the supply of the electric power to the internal load 21.

Further, in Embodiment 1, in the second step, the supply of the electric power from the electric power output unit 18 to each of the external load 17 and the internal load 21 is set to zero. However, the present embodiment is not limited to this. The electric power supplied to the external load 17 or the internal load 21 may be decreased.

**Embodiment 2**

The fuel cell power generation system of Embodiment 2 of the present invention is different from that of Embodiment 1 in that the second step is carried out each time an accumulated value reaches a first voltage accumulated time, the accumulated value being obtained by accumulating a time in which the voltage detected by the voltage detector 13 is equal to or lower than a second voltage lower than the first voltage.

Since the fuel cell power generation system of Embodiment 2 is the same in configuration as the fuel cell power generation system of Embodiment 1, an explanation thereof is omitted.

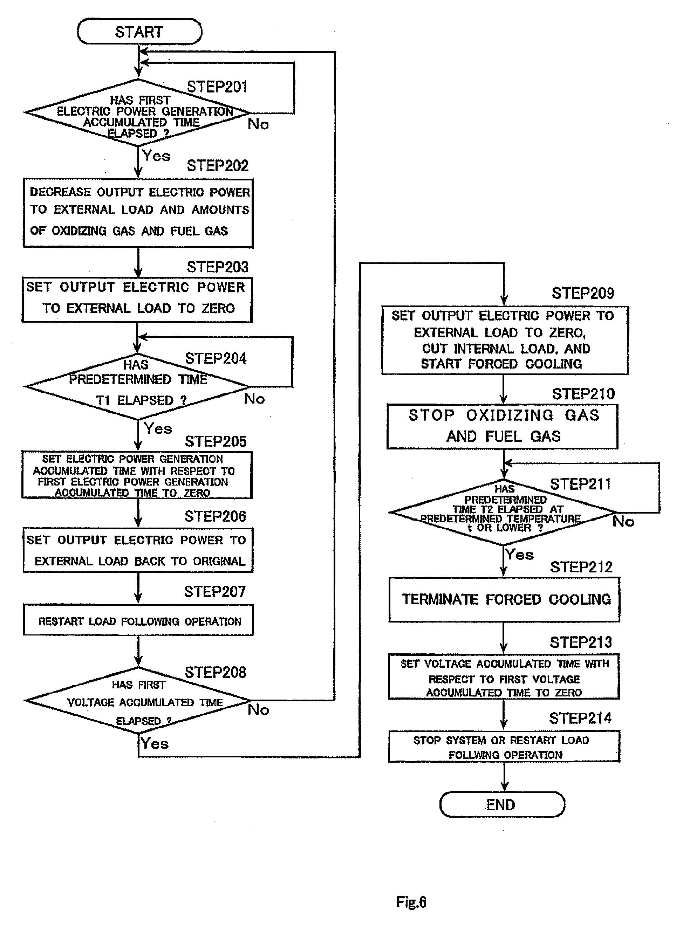

Fig. 6 shows a flow chart of the fuel cell power generation system of Embodiment 2 of the present invention.

As shown in Fig. 6, since Steps 201 to 207 (to be specific, the first step) in which the electrode potential of the cathode 2b of the fuel cell 3 is increased periodically are respectively the same as Steps 101 to 107 of Embodiment 1, explanations thereof are omitted.

In Step 208, the controller 20 determines whether or not the accumulated value obtained by accumulating the time in which the voltage of the fuel cell 3 detected by the voltage detector 13 is equal to or lower than the second voltage has reached the first voltage accumulated time.

Here, the second voltage is lower than the first voltage and may be set arbitrarily. However, for example, it is preferable that the second voltage be lower than a reference voltage (a terminal voltage of a unit cell is 0.6 to 0.8 V and preferably 0.65 to 0.75 V) of the fuel cell 3 during the electric power generation and higher than an abnormal voltage (the terminal voltage of the unit cell is 0.5 V or lower) of the fuel cell 3, the reference voltage being determined in advance based on command output electric power and an endurance time, the abnormal voltage being determined from the viewpoint of safety and the like. Since the terminal voltage of the unit cell decreases in accordance with the operating time of the fuel cell system 3, the reference voltage is set so as to decrease in accordance with the operating time. Moreover, the first voltage accumulated time may be set arbitrarily. For example, it is preferable that the first voltage accumulated time be longer than an extremely short time (several seconds to several minutes, for example, two seconds to three minutes) in which the voltage of the fuel cell 3 temporarily decreases by the impurity and the like but recovers reversibly and be shorter than a time (for example, three days to one month) in which the amount of voltage decrease reaches an amount calculated in advance by experiments or the like. The amount of voltage decrease corresponds to the accumulated amount of sulfur compound which can be removed by one stop operation of the electric power generation of the fuel cell 3 at a set concentration of the sulfur compound. Examples of the first voltage accumulated time are ten days, a week, and two weeks.

Then, when the accumulated time reaches the first voltage accumulated time (Yes in Step 208), the controller 20 causes the electric power output unit 18 to set the output electric power to the external load 17 to zero and opens the relay 25 to electrically cut the internal load 21 from the fuel cell 3. Thus, the controller 20 forcibly stops the electric power generation of the fuel cell 3. Moreover, the controller 20 causes the cooling fluid pump 122 of the cooling mechanism 12 to increase the recovery of the heat generated in the fuel cell 3 and forcibly start cooling the fuel cell 3 (Step 209).

Next, the controller 20 stops the supply of the oxidizing gas and the supply of the fuel gas (Step 210). In order to set the electrode potential of the cathode 2b of the fuel cell 3 to a high potential, it is preferable that the process shift from Step 209 to Step 210 after a predetermined time (about several tens of seconds) has elapsed.

By this sequence, the internal load 21 is electrically separated from the fuel cell 3 at the time of the stop of the fuel cell 3, and the potential of the fuel cell 3 can be a natural potential from the stop of the electric power generation of the fuel cell 3 until the stop of the supply of the oxidizing gas and the fuel gas. On this account, the electrode potential of the cathode 2b becomes the high potential immediately before the fuel cell 3 is cooled, and the sulfur dioxide adsorbed to the catalyst of the cathode 2b is oxidized immediately before it is washed away. Thus, the sulfur dioxide is efficiently washed away and removed by the condensed water generated when the temperature of the fuel cell 3 is decreased.

Next, when the predetermined time T2 has elapsed since the decrease in temperature of the fuel cell 3 up to the predetermined temperature t or lower (Yes in Step 211), the controller 20 stops the cooling mechanism 12 to stop the forced cooling of the fuel cell 3 (Step 212). Next, the controller 20 sets the voltage accumulated time, stored in the storage portion, of the fuel cell 3 with respect to the first voltage accumulated time to zero (Step 213). Thus, the controller 20 performs the second step. Then, after the termination of the second step, the controller 20 restarts the electric power generation of the fuel cell 3 to restart the load following operation of the fuel cell 3 or to stop the operation of the fuel cell power generation system (Step 214).

With this configuration, even in a case where the concentration of the sulfur dioxide contained in the oxidizing gas is high or a case where the influence of the adsorption of the sulfur dioxide on the voltage decrease becomes relatively large since an effective reaction area of the catalyst of the cathode 2b is decreased by, for example, the repetition of the electric power generation of the fuel cell 3 for a long period of time, the sulfur dioxide is removed in accordance with the voltage of the fuel cell 3 which decreases since the sulfur dioxide is adsorbed to the catalyst of the cathode 2b of the fuel cell 3. Therefore, the power generation efficiency and the durability can be improved.

**Embodiment 3**

The fuel cell power generation system of Embodiment 3 of the present invention is different from that of Embodiment 1 in that in the first step carried out each time the accumulated time reaches the first electric power generation accumulated time, the output electric power from the electric power output unit 18 to the external load 17 is not set to zero but is decreased.

Since the fuel cell power generation system of Embodiment 3 is the same in configuration as the fuel cell power generation system of Embodiment 1, an explanation thereof is omitted.

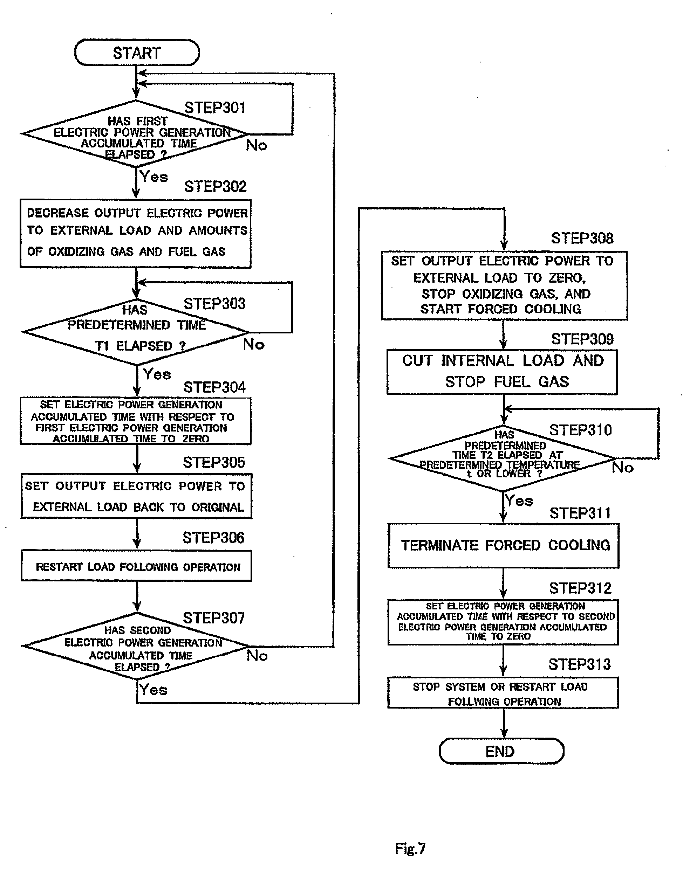

Fig. 7 shows a flow chart of the fuel cell power generation system of Embodiment 3 of the present invention.

As shown in Fig. 7, since Steps 307 to 313 (to be specific, the second step) in which the fuel cell 3 is stopped and cooled each time the second electric power generation accumulated time elapses are respectively the same as Steps 108 to 114 of Embodiment 1, explanations thereof are omitted.

First, the controller 20 obtains the accumulated time of the electric power generation of the fuel cell 3. When the accumulated time passes the first electric power generation accumulated time (Yes in Step 301), the controller 20 controls the electric power output unit 18 to stop the load following operation of the fuel cell 3 and forcibly decrease the output electric power to the external load 17 and decreases the operation amounts of the auxiliary devices 19 (the fuel gas supply mechanism 10 and the oxidizing gas supply mechanism 11) to decrease the supply amounts of the fuel gas and the oxidizing gas (Step 302). At this time, in order to set the electrode potential of the cathode 2b to the high potential, it is preferable that the controller 20 decrease the output electric power of the electric power output unit 18 to the external load 17 up to a low output, and it is more preferable that the controller 20 decrease the output electric power up to a minimum output.

Next, the controller 20 maintains this state until the predetermined time T1 necessary to oxidize the impurity, such as sulfur dioxide, adhered to the cathode 2b elapses.

Next, when the predetermined time has elapsed (Yes in Step 303), the controller 20 sets the accumulated time of the electric power generation of the fuel cell 3 with respect to the first electric power generation accumulated time to zero (Step 304). Then, the controller 20 sets the output electric power of the electric power output unit 18 to the external load 17 back to the same output as in Step 302 once (Step 305), and then restarts the load following operation of the fuel cell 3 (Step 306).

With this configuration, without setting the output of the electric power output unit 18 to zero, the electrode potential of the cathode 2b can be increased such that the voltage of the unit cell becomes 0.85 V or higher in a predetermined voltage range, and the sulfur dioxide adsorbed to the cathode 2b can be oxidized. In contrast, the potential of the cathode 2b becomes lower than the natural potential since the electric power is consumed by the internal load 21. Therefore, the deterioration of the polymer electrolyte 1 and the carbon in the catalyst layer of the cathode 2b can be suppressed.

From the foregoing explanation, many modifications and other embodiments of the present invention are obvious to one skilled in the art. Therefore, the foregoing explanation should be interpreted only as an example and is provided for the purpose of teaching the best mode for carrying out the present invention to one skilled in the art. The structures and/or functional details may be substantially modified within the spirit of the present invention. Moreover, various inventions can be made by suitable combinations of a plurality of components disclosed in the above embodiments.

## Industrial Applicability

As above, the fuel cell power generation system according to the present invention is applicable to fuel cells, fuel cell devices, stationary fuel cell cogeneration systems, and the like, which are less influenced by impurities, are required to improve the power generation efficiency, and use solid polymer electrolyte.

## Reference Signs List

| | |
|---|---|
| 2a | anode |
| 2b | cathode |
| 3 | fuel cell |
| 10 | fuel gas supply mechanism |
| 11 | oxidizing gas supply mechanism |
| 12 | cooling mechanism |
| 13 | voltage detector |
| 17 | external load |
| 18 | electric power output unit |
| 20 | controller |
| 21 | internal load |

**Claims**

1. A fuel cell power generation system comprising:

   a fuel cell configured to generate electric power using a fuel gas supplied to an anode thereof and an oxidizing gas supplied to a cathode thereof;
   a fuel gas supply mechanism configured to supply the fuel gas to the anode;
   an oxidizing gas supply mechanism configured to supply the oxidizing gas to the cathode;
   an electric power output unit configured to supply the electric power generated by the fuel cell to an internal load and external load of the fuel cell system;
   a cooling mechanism configured to cool the fuel cell; and
   a controller configured to carry out a first step in which the controller controls the electric power supplied from the electric power output unit to at least one of the internal load and the external load such that a voltage of the fuel cell temporarily becomes equal to or higher than a first voltage by which a sulfur compound adhered to the cathode oxidizes, and then, carry out a second step in which the controller causes the cooling mechanism to cool the fuel cell to condense steam in the fuel cell and stops supplying the oxidizing gas from the oxidizing gas supply mechanism.

2. The fuel cell power generation system according to claim 1, wherein the controller is configured to carry out the first step each time an accumulated time of electric power generation of the fuel cell reaches a first electric power generation accumulated time and carry out the second step each time the accumulated time of the electric power generation of the fuel cell reaches a second electric power generation accumulated time longer than the first electric power generation accumulated time.

3. The fuel cell power generation system according to claim 1, wherein the controller is configured to cany out the first step each time an oxidizing gas accumulated supply amount obtained by accumulating the amount of oxidizing gas supplied reaches a first accumulated supply amount and carry out the second step each time the oxidizing gas accumulated supply amount reaches a second accumulated supply amount larger than the first accumulated supply amount.

4. The fuel cell power generation system according to claim 1, further comprising a voltage detector configured to measure the voltage of the fuel cell, wherein
   the controller is configured to carry out the first step each time an accumulated time of electric power generation of the fuel cell reaches a first electric power generation accumulated time and carry out the second step each time an accumulated value obtained by accumulating a time in which the voltage detected by the voltage detector is equal to or lower than a second voltage lower than the first voltage reaches a first voltage accumulated time.

5. The fuel cell power generation system according to any one of claims 1 to 4, further comprising a first relay configured to allow or block electrical connection between the external load and the fuel cell, wherein
   the controller is configured to cut the connection between the external load and the fuel cell by the first relay to stop supplying the electric power the external load in the first step.

6. The fuel cell power generation system according to any one of claims 1 to 5, wherein the controller is configured to decrease the electric power supplied from the electric power output unit to at least one of the internal load and the external load in the second step.

7. The fuel cell system according to any one of claims 1 to 5, wherein the controller is configured to stop the electric power supplied from the electric power output unit to the internal load and the external load in the second step.

8. The fuel cell power generation system according to claim 7, further comprising:

   the first relay configured to allow or block the electrical connection between the external load and the fuel cell; and
   a second relay configured to allow or block the electrical connection between the internal load and the fuel cell, wherein
   the controller is configured to cut the connection between the external load and the fuel cell by the first relay and cut the connection between the internal load and the fuel cell by the second relay to stop supplying the electric power to the internal load and the external load in the second step.

**9.** The fuel cell power generation system according to any one of claims 1 to 8, further comprising:

an oxidizing gas supply passage connecting the oxidizing gas supply mechanism and the cathode of the fuel cell;
a first valve disposed on the oxidizing gas supply passage;
an oxidizing gas discharge passage which is connected to the cathode of the fuel cell and to which the oxidizing gas supplied to the cathode of the fuel cell is discharged; and
a second valve disposed on the oxidizing gas discharge passage, wherein
the controller is configured to seal the cathode of the fuel cell by the first valve and the second valve to stop supplying the oxidizing gas from the oxidizing gas supply mechanism to the cathode in the second step.

**10.** The fuel cell power generation system according to any one of claims 1 to 9, wherein the controller causes the fuel gas supply mechanism and the oxidizing gas supply mechanism to decrease the amount of fuel gas supplied and the amount of oxidizing gas supplied in the first step.

**11.** A method for operating a fuel cell power generation system,
the fuel cell power generation system including:

a fuel cell configured to generate electric power using a fuel gas supplied to an anode thereof and an oxidizing gas supplied to a cathode thereof;
a fuel gas supply mechanism configured to supply the fuel gas to the anode;
an oxidizing gas supply mechanism configured to supply the oxidizing gas to the cathode;
an electric power output unit configured to supply the electric power generated by the fuel cell to an internal load and external load of the fuel cell system; and
a cooling mechanism configured to cool the fuel cell,
the method comprising:

a first step of controlling the electric power supplied from the electric power output unit to at least one of the internal load and the external load such that a voltage of the fuel cell temporarily becomes equal to or higher than a first voltage by which a sulfur compound adhered to the cathode oxidizes; and
a second step of causing the cooling mechanism to cool the fuel cell to condense steam in the fuel cell and stopping supplying the oxidizing gas from the oxidizing gas supply mechanism, the second step being carried out after the first step.

## Patentansprüche

**1.** Brennstoffzellen-Energieerzeugungssystem, das umfasst
eine Brennstoffzelle, die so eingerichtet ist, dass sie Elektroenergie unter Verwendung eines Brennstoffgases, das einer Anode derselben zugeführt wird, und eines oxidierenden Gases erzeugt, das einer Kathode derselben zugeführt wird;
einen Mechanismus zum Zuführen von Brennstoffgas, der so eingerichtet ist, dass er der Anode das Brennstoffgas zuführt;
einen Mechanismus zum Zuführen von oxidierendem Gas, der so eingerichtet ist, dass er der Kathode das oxidierende Gas zuführt;
eine Elektroenergie-Ausgabeeinheit, die so eingerichtet ist, dass sie die durch die Brennstoffzelle erzeugte Elektroenergie einer internen Last und einer externen Last des Brennstoffzellensystems zuführt;
einen Kühlmechanismus, der so eingerichtet ist, dass er die Brennstoffzelle kühlt; und
eine Steuereinrichtung, die so eingerichtet ist, dass sie einen ersten Schritt ausführt, in dem die Steuereinrichtung die von der Elektroenergie-Ausgabeeinheit der internen Last oder/und der externen Last zugeführte Elektroenergie so steuert, dass eine Spannung der Brennstoffzelle vorübergehend genauso hoch ist wie oder höher als eine erste Spannung, durch die eine an der Kathode haftende Schwefelverbindung oxidiert, und dann einen zweiten Schritt ausführt, in dem die Steuereinrichtung den Kühlmechanismus veranlasst, die Brennstoffzelle zu kühlen, um Dampf in der Brennstoffzelle zu kondensieren, und die Zufuhr des oxidierenden Gases von dem Mechanismus zum Zuführen von oxidierendem Gas unterbricht.

**2.** Brennstoffzellen-Energieerzeugungssystem nach Anspruch 1, wobei die Steuereinrichtung so eingerichtet ist, dass sie den ersten Schritt immer dann ausführt, wenn eine akkumulierte Zeit für Elektroenergieerzeugung der Brennstoffzelle eine erste akkumulierte Zeit für Elektroenergieerzeugung erreicht, und den zweiten Schritt immer dann ausführt, wenn die akkumulierte Zeit für die Elektroenergieerzeugung der Brennstoffzelle eine zweite akkumulierte Zeit für Elektroenergieerzeugung erreicht, die länger ist als die erste akkumulierte Zeit für Elektroenergieerzeugung.

3. Brennstoffzellen-Energieerzeugungssystem nach Anspruch 1, wobei die Steuereinrichtung so eingerichtet ist, dass sie den ersten Schritt immer dann ausführt, wenn eine akkumulierte Menge an zugeführtem oxidierendem Gas, die ermittelt wird, indem die Menge an zugeführtem oxidierendem Gas akkumuliert wird, eine erste akkumulierte Zuführmenge erreicht, und den zweiten Schritt immer dann ausführt, wenn die akkumulierte Menge an zugeführtem oxidierendem Gas eine zweite akkumulierte Zuführmenge erreicht, die größer ist als die erste akkumulierte Zuführmenge.

4. Brennstoffzellen-Energieerzeugungssystem nach Anspruch 1, das des Weiteren eine Spannungs-Erfassungseinrichtung umfasst, die so eingerichtet ist, dass sie die Spannung der Brennstoffzelle misst, wobei die Steuereinrichtung so eingerichtet ist, dass sie den ersten Schritt immer dann ausführt, wenn eine akkumulierte Zeit für Elektroenergieerzeugung der Brennstoffzelle eine erste akkumulierte Zeit für Elektroenergieerzeugung erreicht, und den zweiten Schritt immer dann ausführt, wenn ein akkumulierter Wert, der ermittelt wird, indem eine Zeit akkumuliert wird, während der die durch die Spannungs-Erfassungseinrichtung erfasste Spannung genauso hoch ist wie oder niedriger als eine zweite Spannung, die niedriger ist als die erste Spannung, eine erste akkumulierte Spannungs-Zeit erreicht.

5. Brennstoffzellen-Energieerzeugungssystem nach einem der Ansprüche 1 bis 4, das des Weiteren ein erstes Relais umfasst, das so eingerichtet ist, dass es elektrische Verbindung zwischen der externen Last und der Brennstoffzelle zulässt oder verhindert, wobei die Steuereinrichtung so eingerichtet ist, dass sie die Verbindung zwischen der externen Last und der Brennstoffzelle mit dem ersten Relais trennt, um die Zufuhr der Elektroenergie zu der externen Last in dem ersten Schritt zu unterbrechen.

6. Brennstoffzellen-Energieerzeugungssystem nach einem der Ansprüche 1 bis 5, wobei die Steuereinrichtung so eingerichtet ist, dass sie die von der Elektroenergie-Ausgabeeinheit der internen Last oder/und der externen Last in dem zweiten Schritt zugeführte Elektroenergie verringert.

7. Brennstoffzellensystem nach einem der Ansprüche 1 bis 5, wobei die Steuereinrichtung so eingerichtet ist, dass sie die von der Elektroenergie-Ausgabeeinheit der internen Last und der externen Last in dem zweiten Schritt zugeführte Elektroenergie unterbricht.

8. Brennstoffzellen-Energieerzeugungssystem nach Anspruch 7, das des Weiteren umfasst:

   das erste Relais, das so eingerichtet ist, dass es die elektrische Verbindung zwischen der externen Last und der Brennstoffzelle zulässt oder verhindert; und
   ein zweites Relais, das so eingerichtet ist, dass es die elektrische Verbindung zwischen der internen Last und der Brennstoffzelle zulässt oder verhindert, wobei
   die Steuereinrichtung so eingerichtet ist, dass sie die Verbindung zwischen der externen Last und der Brennstoffzelle mit dem ersten Relais trennt und die Verbindung zwischen der internen Last und der Brennstoffzelle mit dem zweiten Relais trennt, um die Zufuhr der Elektroenergie zu der internen Last und der externen Last in dem zweiten Schritt zu unterbrechen.

9. Brennstoffzellen-Energieerzeugungssystem nach einem der Ansprüche 1 bis 8, das des Weiteren umfasst:

   einen Kanal zum Zuführen von oxidierendem Gas, der den Mechanismus zum Zuführen von oxidierendem Gas und die Kathode der Brennstoffzelle verbindet;
   ein erstes Ventil, das an dem Kanal zum Zuführen von oxidierendem Gas angeordnet ist;
   einen Kanal zum Ableiten von oxidierendem Gas, der mit der Kathode der Brennstoffzelle verbunden ist, und zu dem das der Kathode der Brennstoffzelle zugeführte oxidierende Gas abgeleitet wird; und
   ein zweites Ventil, das an dem Kanal zum Ableiten von oxidierendem Gas angeordnet ist, wobei
   die Steuereinrichtung so eingerichtet ist, dass sie die Kathode der Brennstoffzelle mit dem ersten Ventil und dem zweiten Ventil abdichtet, um Zufuhr des oxidierenden Gases von dem Mechanismus zum Zuführen von oxidierendem Gas zu der Kathode in dem zweiten Schritt zu unterbrechen.

10. Brennstoffzellen-Energieerzeugungssystem nach einem der Ansprüche 1 bis 9, wobei die Steuereinrichtung den Mechanismus zum Zuführen von Brennstoffgas und den Mechanismus zum Zuführen von oxidierendem Gas veranlasst, die zugeführte Menge an Brennstoffgas und zugeführte Menge an oxidierendem Gas in dem ersten Schritt zu verringern.

**11.** Verfahren zum Betreiben eines Brennstoffzellen-Energieerzeugungssystems,
wobei das Brennstoffzellen-Energieerzeugungssystem enthält:

eine Brennstoffzelle, die so eingerichtet ist, dass sie Elektroenergie unter Verwendung eines Brennstoffgases, das einer Anode derselben zugeführt wird, und eines oxidierenden Gases erzeugt, das einer Kathode derselben zugeführt wird;
einen Mechanismus zum Zuführen von Brennstoffgas, der so eingerichtet ist, dass er der Anode das Brennstoffgas zuführt;
einen Mechanismus zum Zuführen von oxidierendem Gas, der so eingerichtet ist, dass er der Kathode das oxidierende Gas zuführt;
eine Elektroenergie-Ausgabeeinheit, die so eingerichtet ist, dass sie die durch die Brennstoffzelle erzeugte Elektroenergie einer internen Last und einer externen Last des Brennstoffzellensystems zuführt;
einen Kühlmechanismus, der so eingerichtet ist, dass er die Brennstoffzelle kühlt;
wobei das Verfahren umfasst:
einen ersten Schritt, in dem die von der Elektroenergie-Ausgabeeinheit der internen Last oder/und der externen Last zugeführte Elektroenergie so gesteuert wird, dass eine Spannung der Brennstoffzelle vorübergehend genauso hoch ist wie oder höher als eine erste Spannung, durch die eine an der Kathode haftende Schwefelverbindung oxidiert; und
einen zweiten Schritt, in dem der Kühlmechanismus veranlasst wird, die Brennstoffzelle zu kühlen, um Dampf in der Brennstoffzelle zu kondensieren, und die Zufuhr des oxidierenden Gases von dem Mechanismus zum Zuführen von oxidierendem Gas unterbrochen wird, wobei der zweite Schritt nach dem ersten Schritt ausgeführt wird.

**Revendications**

**1.** Système de génération d'énergie de pile à combustible, comprenant :

une pile à combustible configurée pour générer de l'énergie électrique en utilisant un gaz combustible alimenté à une anode de la pile et un gaz oxydant alimenté à une cathode de la pile ;
un mécanisme d'alimentation de gaz combustible configuré pour alimenter le gaz combustible à l'anode ;
un mécanisme d'alimentation de gaz oxydant configuré pour alimenter le gaz oxydant à la cathode ;
une unité de sortie d'énergie électrique configurée pour alimenter l'énergie électrique générée par la pile à combustible à une charge interne et à une charge externe du système de pile à combustible ;
un mécanisme de refroidissement configuré pour refroidir la pile à combustible ; et
un contrôleur configuré pour mettre en oeuvre une première étape dans laquelle le contrôleur contrôle l'énergie électrique alimentée par l'unité de sortie d'énergie électrique à au moins une charge parmi la charge interne et la charge externe, de telle sorte qu'une tension de la pile à combustible devient temporairement supérieure ou égale à une première tension avec laquelle un composé soufré qui adhère à la cathode est oxydé, et pour ensuite mettre en oeuvre une deuxième étape dans laquelle le contrôleur commande au mécanisme de refroidissement de refroidir la pile à combustible pour condenser de la vapeur dans la pile à combustible et arrête l'alimentation du gaz oxydant provenant du mécanisme d'alimentation de gaz oxydant.

**2.** Système de génération d'énergie de pile à combustible selon la revendication 1, dans lequel le contrôleur est configuré pour mettre en oeuvre la première étape chaque fois qu'un temps accumulé de génération d'énergie électrique de la pile à combustible atteint un premier temps accumulé de génération d'énergie électrique, et pour mettre en oeuvre la deuxième étape chaque fois que le temps accumulé de la génération d'énergie électrique de la pile à combustible atteint un deuxième temps accumulé de génération d'énergie électrique plus long que le premier temps accumulé de génération d'énergie électrique.

**3.** Système de génération d'énergie de pile à combustible selon la revendication 1, dans lequel le contrôleur est configuré pour mettre en oeuvre la première étape chaque fois qu'une quantité accumulée d'alimentation du gaz oxydant obtenue en accumulant la quantité de gaz oxydant alimenté atteint une première quantité accumulée d'alimentation, et pour mettre en oeuvre la deuxième étape chaque fois que la quantité accumulée d'alimentation du gaz oxydant atteint une deuxième quantité accumulée d'alimentation supérieure à la première quantité accumulée d'alimentation.

4. Système de génération d'énergie de pile à combustible selon la revendication 1, comprenant en outre un détecteur de tension configuré pour mesurer la tension de la pile à combustible, dans lequel
le contrôleur est configuré pour mettre en oeuvre la première étape chaque fois qu'un temps accumulé de génération d'énergie électrique de la pile à combustible atteint un premier temps accumulé de génération d'énergie électrique, et pour mettre en oeuvre la deuxième étape chaque fois qu'une valeur accumulée, obtenue en accumulant un temps où la tension détectée par le détecteur de tension est inférieure ou égale à une deuxième tension inférieure à la première tension, atteint un premier temps accumulé de tension.

5. Système de génération d'énergie de pile à combustible selon l'une quelconque des revendications 1 à 4, comprenant en outre un premier relais configuré pour autoriser ou bloquer une connexion électrique entre la charge externe et la pile à combustible, dans lequel
le contrôleur est configuré pour couper la connexion entre la charge externe et la pile à combustible à l'aide du premier relais pour arrêter l'alimentation de l'énergie électrique à la charge externe lors de la première étape.

6. Système de génération d'énergie de pile à combustible selon l'une quelconque des revendications 1 à 5, dans lequel le contrôleur est configuré pour diminuer l'énergie électrique alimentée par l'unité de sortie d'énergie électrique à au moins une charge parmi la charge interne et la charge externe lors de la deuxième étape.

7. Système de pile à combustible selon l'une quelconque des revendications 1 à 5, dans lequel le contrôleur est configuré pour arrêter l'énergie électrique alimentée par l'unité de sortie d'énergie électrique à la charge interne et à la charge externe lors de la deuxième étape.

8. Système de génération d'énergie de pile à combustible selon la revendication 7, comprenant en outre :

   le premier relais configuré pour autoriser ou bloquer la connexion électrique entre la charge externe et la pile à combustible ; et
   un deuxième relais configuré pour autoriser ou bloquer la connexion électrique entre la charge interne et la pile à combustible, dans lequel
   le contrôleur est configuré pour couper la connexion entre la charge externe et la pile à combustible à l'aide du premier relais et pour couper la connexion entre la charge interne et la pile à combustible à l'aide du deuxième relais pour arrêter l'alimentation de l'énergie électrique à la charge interne et à la charge externe lors de la deuxième étape.

9. Système de génération d'énergie de pile à combustible selon l'une quelconque des revendications 1 à 8, comprenant en outre :

   un passage d'alimentation de gaz oxydant qui connecte le mécanisme d'alimentation de gaz oxydant à la cathode de la pile à combustible ;
   une première vanne agencée sur le passage d'alimentation de gaz oxydant ;
   un passage de décharge de gaz oxydant qui est connecté à la cathode de la pile à combustible et dans lequel le gaz oxydant alimenté à la cathode de la pile à combustible est déchargé ; et
   une deuxième vanne agencée sur le passage de décharge de gaz oxydant, dans lequel
   le contrôleur est configuré pour sceller la cathode de la pile à combustible à l'aide de la première vanne et de la deuxième vanne pour arrêter l'alimentation du gaz oxydant provenant du mécanisme d'alimentation de gaz oxydant à la cathode lors de la deuxième étape.

10. Système de génération d'énergie de pile à combustible selon l'une quelconque des revendications 1 à 9, dans lequel le contrôleur commande au mécanisme d'alimentation de gaz combustible et au mécanisme d'alimentation de gaz oxydant de diminuer la quantité de gaz combustible alimenté et la quantité de gaz oxydant alimenté lors de la première étape.

11. Procédé d'utilisation d'un système de génération d'énergie de pile à combustible,
le système de génération d'énergie de pile à combustible comprenant :

   une pile à combustible configurée pour générer de l'énergie électrique en utilisant un gaz combustible alimenté à une anode de la pile et un gaz oxydant alimenté à une cathode de la pile ;
un mécanisme d'alimentation de gaz combustible configuré pour alimenter le gaz combustible à l'anode ;
un mécanisme d'alimentation de gaz oxydant configuré pour alimenter le gaz oxydant à la cathode ;
une unité de sortie d'énergie électrique configurée pour alimenter l'énergie électrique générée par la pile à combustible à une charge interne et à une charge externe du système de pile à combustible ; et
un mécanisme de refroidissement configuré pour refroidir la pile à combustible,
le procédé comprenant :

une première étape consistant à contrôler l'énergie électrique alimentée par l'unité de sortie d'énergie électrique à au moins une charge parmi la charge interne et la charge externe, de telle sorte qu'une tension de la pile à combustible devient temporairement supérieure ou égale à une première tension avec laquelle un composé soufré qui adhère à la cathode est oxydé ; et
une deuxième étape consistant à commander au mécanisme de refroidissement de refroidir la pile à combustible pour condenser de la vapeur dans la pile à combustible, et à arrêter l'alimentation du gaz oxydant provenant du mécanisme d'alimentation de gaz oxydant, la deuxième étape étant mise en oeuvre après la première étape.

Fig.1

Fig.2

EP 2 475 038 B1

**START**

**STEP101** HAS FIRST ELECTRIC POWER GENERATION ACCUMULATED TIME ELAPSED ? — No

Yes

**STEP102** DECREASE OUTPUT ELECTRIC POWER TO EXTERNAL LOAD AND AMOUNTS OF OXIDIZING GAS AND FUEL GAS

**STEP103** SET OUTPUT ELECTRIC POWER TO EXTERNAL LOAD TO ZERO

**STEP104** HAS PREDETERMINED TIME T1 ELAPSED ? — No

Yes

**STEP105** SET ELECTRIC POWER GENERATION ACCUMULATED TIME WITH RESPECT TO FIRST ELECTRIC POWER GENERATION ACCUMULATED TIME TO ZERO

**STEP106** SET OUTPUT ELECTRIC POWER TO EXTERNAL LOAD BACK TO ORIGINAL

**STEP107** RESTART LOAD FOLLOWING OPERATION

**STEP108** HAS SECOND ELECTRIC POWER GENERATION ACCUMULATED TIME ELAPSED ? — No

Yes

**STEP109** SET OUTPUT ELECTRIC POWER TO EXTERNAL LOAD TO ZERO, STOP OXIDIZING GAS, AND START FORCED COOLING

**STEP110** CUT INTERNAL LOAD AND STOP FUEL GAS

**STEP111** HAS PREDETERMINED TIME T2 ELAPSED AT PREDETERMINED TEMPERATURE t OR LOWER ? — No

Yes

**STEP112** TERMINATE FORCED COOLING

**STEP113** SET ELECTRIC POWER GENERATION ACCUMULATED TIME WITH RESPECT TO SECOND ELECTRIC POWER GENERATION ACCUMULATED TIME TO ZERO

**STEP114** STOP SYSTEM OR RESTART LOAD FOLLWING OPERATION

**END**

Fig.3

Fig.4

Fig.5

EP 2 475 038 B1

START

STEP201
HAS FIRST
ELECTRIC POWER GENERATION
ACCUMULATED TIME
ELAPSED ?          No

Yes    STEP202

DECREASE OUTPUT ELECTRIC POWER
TO EXTERNAL LOAD AND AMOUNTS
OF OXIDIZING GAS AND FUEL GAS

STEP203

SET OUTPUT ELECTRIC POWER
TO EXTERNAL LOAD TO ZERO

STEP204
HAS
PREDETERMINED TIME
T1 ELAPSED ?          No

Yes    STEP205

SET ELECTRIC POWER GENERATION
ACCUMULATED TIME WITH RESPECT TO
FIRST ELECTRIC POWER GENERATION
ACCUMULATED TIME TO ZERO

STEP206

SET OUTPUT ELECTRIC POWER TO
EXTERNAL LOAD BACK TO ORIGINAL

STEP207

RESTART LOAD FOLLOWING OPERATION

STEP208
HAS FIRST
VOLTAGE ACCUMULATED TIME
ELAPSED ?          No

Yes

STEP209

SET OUTPUT ELECTRIC POWER TO
EXTERNAL LOAD TO ZERO,
CUT INTERNAL LOAD, AND
START FORCED COOLING

STEP210

STOP OXIDIZING GAS
AND FUEL GAS

STEP211
HAS
PREDETERMINED
TIME T2 ELAPSED AT
PREDETERMINED TEMPERATURE
t OR LOWER ?          No

Yes    STEP212

TERMINATE FORCED COOLING

STEP213

SET VOLTAGE ACCUMULATED TIME WITH
RESPECT TO FIRST VOLTAGE
ACCUMULATED TIME TO ZERO

STEP214

STOP SYSTEM OR RESTART LOAD
FOLLWING OPERATION

END

Fig.6

28

START

STEP301

HAS FIRST
ELECTRIC POWER GENERATION
ACCUMULATED TIME
ELAPSED ?

No

Yes STEP302

DECREASE OUTPUT ELECTRIC POWER
TO EXTERNAL LOAD AND AMOUNTS
OF OXIDIZING GAS AND FUEL GAS

STEP303

HAS
PREDETERMINED TIME
T1 ELAPSED ?

No

Yes STEP304

SET ELECTRIC POWER GENERATION
ACCUMULATED TIME WITH RESPECT TO
FIRST ELECTRIC POWER GENERATION
ACCUMULATED TIME TO ZERO

STEP305

SET OUTPUT ELECTRIC POWER TO
EXTERNAL LOAD BACK TO ORIGINAL

STEP306

RESTART LOAD FOLLOWING OPERATION

STEP307

HAS SECOND
ELECTRIC POWER GENERATION
ACCUMULATED TIME
ELAPSED ?

No

Yes

STEP308

SET OUTPUT ELECTRIC POWER TO
EXTERNAL LOAD TO ZERO,
STOP OXIDIZING GAS, AND
START FORCED COOLING

STEP309

CUT INTERNAL LOAD AND
STOP FUEL GAS

STEP310

HAS
PREDETERMINED
TIME T2 ELAPSED AT
PREDETERMINED TEMPERATURE
t OR LOWER ?

No

Yes STEP311

TERMINATE FORCED COOLING

STEP312

SET ELECTRIC POWER GENERATION
ACCUMULATED TIME WITH RESPECT TO SECOND
ELECTRIC POWER GENERATION ACCUMULATED
TIME TO ZERO

STEP313

STOP SYSTEM OR RESTART LOAD
FOLLWING OPERATION

END

Fig.7

29

EP 2 475 038 B1

Fig.8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008218050 A